# EUROPÄISCHE PATENTSCHRIFT

(11) **EP 4 646 630 B1**
(45) Veröffentlichungstag und Bekanntmachung des Hinweises auf die Patenterteilung: **21.10.2026**
(21) Anmeldenummer: 23700059.1
(22) Anmeldetag: 03.01.2023
(51) Int. Cl.: B41F 23/04, G03F 7/00, B41F 19/02, B44B 5/02, B41F 19/00, G03F 7/16

(54) **VORRICHTUNG UND VERFAHREN ZUM BEARBEITEN EINES SUBSTRATS IN EINEM EVAKUIERTEN BEARBEITUNGSRAUM**
DEVICE AND METHOD FOR PROCESSING A SUBSTRATE IN AN EVACUATED PROCESSING CHAMBER
DISPOSITIF ET PROCÉDÉ DE TRAITEMENT D'UN SUBSTRAT DANS UNE CHAMBRE DE TRAITEMENT SOUS VIDE

(43) Veröffentlichungstag der Anmeldung: 12.11.2025
(60) Teilanmeldung: 26203395.4
(73) Patentinhaber: EV Group E. Thallner GmbH, 4782 St. Florian am Inn (AT)
(72) Erfinder: EIBELHUBER, Martin, 4782 St. Florian am Inn (AT)
(74) Vertreter: Kaldewey, Tim Merlin
(86) Internationale Anmeldenummer: PCT/EP2023/050054
(87) Internationale Veröffentlichungsnummer: WO 2024/146688

(56) Entgegenhaltungen:
- CN-B- 102 591 143
- US-A1- 2016 263 811
- US-B2- 10 493 747
- US-B2- 7 500 431
- US-B2- 7 704 425

## Beschreibung

Die vorliegende Erfindung betrifft ein Verfahren und eine Vorrichtung zum Nanoprägen von Substraten mit verbesserter Ausrichtung.

Im Stand der Technik ist bei einigen Bearbeitungsverfahren die Bearbeitung von Substraten im Vakuum vorteilhaft. Dazu muss häufig die gesamte Vorrichtung oder zumindest das entsprechende Modul evakuiert werden. Dabei ist insbesondere der lange Evakuierungsprozess nachteilig, da die Produktivität durch häufiges und langes Evakuieren sinkt. Dabei ist das Bearbeiten des Substrats im Vakuum häufig notwendig, um Prägefehler, insbesondere Lufteinschlüsse, zu verhindern.

Dabei betrifft die Erfindung insbesondere ein Verfahren und eine Vorrichtung zum UV-NIL Prägen, wobei mit einem flexiblen Folienstempel Nanostrukturen erzeugbar sind.

Nanoimprint Lithographie (NIL) ist ein Abformungsverfahren, bei dem Mikro- und/oder Nanostrukturen von einem Stempel in aushärtbare Materialien, z.B. Lack, abgeformt werden. Dabei ist eine Abformung einer großen Zahl von Nanostruktur-Systemen möglich.

Prinzipiell unterscheidet man zwischen thermischen NIL (hot-embossing NIL) und UV-basierten NIL Verfahren. Bei UV-NIL wird der Stempel bei Raumtemperatur in den fließfähigen Lack gedrückt. Auf Grund der Viskosität des Photoresist-Lacks werden durch Kapillarwirkung die Zwischenräume des Stempels vollständig damit ausgefüllt. Der UV-Lack vernetzt bei der Belichtung mit UV-Strahlung zu einem stabilen Polymer (Aushärtung).

Die Strukturierung mit weichen Polymer-Stempeln hat mehrere Vorteile gegenüber harten Stempeln. Der Grund liegt in der leichten Herstellung der Stempel, effizienten Prägevorgängen, sehr guten Oberflächeneigenschaften der jeweiligen Stempelmaterialien, den geringen Kosten, der Reproduzierbarkeit des Prägeproduktes und vor allem in der Möglichkeit der elastischen Verformung des Stempels während der Entformung.

Die Herstellung hochpräziser Nanostrukturen auf großen Flächen kann durch ein Rolle-Verfahren ohne Vakuum (SmartNIL) durchgeführt werden. In WO2014/037044A1 werden ein Verfahren und eine Vorrichtung beschrieben, bei welchen ein Mikro- und/oder Nano-Strukturstempel, insbesondere ein flexibel ausgebildeter Folienstempel und einem Rahmen verwendet werden. Zudem müssen die Strukturen aus dem Folienstempel aus WO2014/037044A1 mit einem Prägeelement, insbesondere eine starre Prägerolle, in das Prägematerial gedrückt werden.

In der Druckschrift WO2015/161868A1 wird ein Nanostrukturstempel mit einer Vorspannung vor dem Kontaktieren beaufschlagt. Die Vorspannung wird durch eine Verformung des Nanostrukturstempels mittels Verformungsmittel erreicht. Damit können Positionsungenauigkeiten sowie weitere Prägefehler das Prägeergebnis verschlechtern.

Die Vorrichtung aus WO2015/161868A1 kann auch im Vakuum betrieben werden, wobei die gesamte Vorrichtung evakuiert werden muss. Dabei ist der Prägestempel kein flexibler, weicher Folienstempel an einem Folienrahmen gespannt, sondern ein harter Polymerstempel.

US7704425 B2 offenbart ein Musterübertragungsverfahren für die Imprint-Lithographie.

Es ist daher die Aufgabe der Erfindung, die im Stand der Technik aufgeführten Nachteile zumindest zum Teil zu beseitigen, insbesondere vollständig zu beseitigen. Insbesondere ist es eine Aufgabe der Erfindung, ein verbessertes Verfahren sowie eine verbesserte Vorrichtung zum Nanoprägen von Substraten aufzuzeigen.

Die vorliegende Aufgabe wird mit den Merkmalen der nebengeordneten Ansprüche gelöst. Vorteilhafte Weiterbildungen der Erfindung sind in den Unteransprüchen angegeben.

Demnach betrifft die Erfindung ein Verfahren zum Nanoprägen eines Substrats mit zumindest den folgenden Schritten: a) Bereitstellung einer Substrataufnahmeeinrichtung zur Aufnahme des Substrats, b) Bereitstellung einer Einrichtung zum Bearbeiten des Substrats, c) Ausbildung eines lokalen und fluidisch dichten Bearbeitungsraums zwischen der Substrataufnahmeeinrichtung und der Einrichtung, d) Evakuierung des Bearbeitungsraums und e) Bearbeitung des Substrats, wobei die Evakuierung in Schritt d) nach der Ausbildung des Bearbeitungsraums in Schritt c) erfolgt.

Dabei kann statt eines Substrates auch ein Substratstapel bearbeitet werden. Im Folgenden wird das Verfahren und die Vorrichtung im Zusammenhang mit einem Substrat beschrieben, jedoch kann auch ein Substratstapel entsprechend bearbeitet werden. Das Bearbeiten kann auch ein beidseitiges Bearbeiten des Substrats umfassen, wobei eine mehrfach beziehungsweise dreifach gestapelte Anordnung (engl.: triple stack) verwendet wird. Damit kann beispielsweise ein Substrat beidseitig geprägt werden.

Somit kann vorteilhaft ein Bearbeitungsraum ausgebildet werden, welcher lokal beziehungsweise deutlich kleiner ist als der Raum um die Vorrichtung. Der Bearbeitungsraum wird dabei zumindest teilweise durch die Einrichtung und die Substrataufnahmeeinrichtung ausgebildet bzw. abgedichtet. In anderen Worten kann ein räumlich abgegrenzter Bearbeitungsraum um das Substrat ausgebildet werden. Dieser kann durch das geringe Volumen besonders schnell und effizient evakuiert werden.

Die Evakuierung erfolgt durch Mittel zur Evakuierung, welche an der Substrataufnahmeeinrichtung und/oder der Einrichtung angeordnet sind, so dass nach einer Ausbildung des Bearbeitungsraum dieser evakuiert werden kann. Dabei ist das Substrat innerhalb des Bearbeitungsraumes angeordnet. Die Bearbeitung findet dabei in dem Bearbeitungsraum statt, wobei dieser zumindest teilweise evakuiert ist.

In einer bevorzugten Ausführungsform des Verfahrens ist vorgesehen, dass die Ausbildung des Bearbeitungsraums durch Annäherung der Substrataufnahmeeinrichtung und der Einrichtung erfolgt, wobei vor der Annäherung die Einrichtung und die Substrataufnahmeeinrichtung zueinander ausgerichtet werden.

Dabei wird bei dem Ausrichten und/oder bei der Annäherung die Substrataufnahmeeinrichtung und die Einrichtung zueinander so ausgerichtet, dass eine optimale Bearbeitung und ein optimales Bearbeitungsergebnis ermöglicht ist. Insbesondere für Präge- oder Bondprozesse ist eine exakte Ausrichtung notwendig. Durch eine Ausrichtung der Substrataufnahmeeinrichtung und der Einrichtung zueinander, kann vorteilhaft auch das Substrat genau ausgerichtet beziehungsweise angeordnet werden.

Das Substrat wird in der Substrataufnahmeeinrichtung vorzugsweise mit Fixierelementen fixiert. Die Annäherung und die Ausrichtung erfolgen dabei vorzugsweise durch Aktuatoren oder sonstige Mittel zur Ausrichtung oder Annäherung. Das Ausrichten und die Annäherung in Schritt c) können auch in unterschiedlicher Reihenfolge durchgeführt werden. Dabei ist denkbar, dass zunächst ausgerichtet und anschließend eine Annäherung der Substrataufnahmeeinrichtung und der Einrichtung durchgeführt wird. Nach der Annäherung und der Ausbildung des Bearbeitungsraums, kann zusätzlich eine Ausrichtung des Substrats bzw. der Bearbeitungsmittel erfolgen. Auch eine parallele Durchführung der Annäherung und der Ausrichtung ist denkbar.

Durch die Annäherung der Substrataufnahmeeinrichtung und der Einrichtung wird ein lokaler und fluidisch dichter Bearbeitungsraum um das Substrat geschaffen. Dieser Bearbeitungsraum ist evakuierbar und zumindest teilweise zwischen beiden Aufnahmeeinrichtungen ausgebildet. Dabei kann der Bearbeitungsraum auch teilweise durch Dichtungen, welche vorzugsweise zumindest an der Substrataufnahmeeinrichtung angebracht sind, ausgebildet werden. Dabei kann auch jeweils ein Teil der Substrataufnahmeeinrichtung oder der Einrichtung die Dichtungen ausbilden. Bevorzugt wird ein Dichtring zur Abdichtung beziehungsweise Ausbildung des Bearbeitungsraumes verwendet.

Dadurch dass die Ausrichtung und Annäherung vor der Evakuierung durchgeführt wird, kann vorteilhaft eine lokale Evakuierung danach erfolgen, wobei Ausrichtungsfehler vermieden werden. Zudem kann vorteilhaft lediglich der lokale Bearbeitungsraum evakuiert werden. Eine Evakuierung der Vorrichtung oder des gesamten Moduls ist somit nicht notwendig. Auf diese Weise ist eine besonders schnelle und effiziente Bearbeitung des Substrats möglich.

In einer bevorzugten Ausführungsform des Verfahrens ist vorgesehen, dass die Ausbildung des Bearbeitungsraums durch steuerbare Abdichtungsmittel erfolgt. In anderen Worten findet keine Annäherung zur Ausbildung des Bearbeitungsraums statt, sondern es wird durch die Abdichtungsmittel der Bearbeitungsraum abgedichtet. Dabei kann das Substrat beispielsweise von der Seite geladen werden, so dass die Bauform der Vorrichtung besonders klein konzipiert werden kann. Mithin muss vorteilhaft nur ein geringer Raum evakuiert werden, so dass die Bearbeitungszeit verringert werden kann.

In dem Verfahrens ist vorgesehen, dass die Einrichtung einen flexiblen Folienstempel zum Prägen des Substrats aufweist und bei dem Bearbeiten des Substrats ein fluidisch dichter Spülraum zwischen der Einrichtung und dem Folienstempel zur Krümmung des Folienstempels gespült wird, wobei der Bearbeitungsraum und der Spülraum fluidisch durch den Folienstempel voneinander getrennt sind. In anderen Worten sind zwei verschiedene Druckbereiche in der Vorrichtung ausgebildet, welche durch den Folienstempel fluidisch voneinander getrennt sind, so dass durch die Druckunterschiede der Folienstempel gezielt zum Prägen und Entformen verformt werden kann. Dabei wird der Spülraum von Spülmitteln, welche gleichzeitig als Evakuierungsmittel ausgebildet sein können, mit einem Fluid gespült, so dass der Folienstempel in Richtung des Substrats gekrümmt bzw. durchgebogen wird. Die Prägekraft sowie Verformung des Folienstempels kann vorteilhaft durch die Druckdifferenz eingestellt werden. Zudem kann eine Entformung nach dem Bearbeiten bzw. Prägen vorteilhaft schonend durch eine Reduzierung des Druckunterschieds erfolgen bzw. unterstütz werden. Dabei kann ebenfalls der Druck im Bearbeitungsraum entsprechend angepasst werden.

Der Spülraum wird dabei zumindest teilweise erst durch ein Spülen mit einem Fluid durch die Spülmittel ausgebildet, da der Folienstempel direkt an einem Abschnitt der Einrichtung und/oder an einem Folienrahmen anliegt. Jedoch ist auch denkbar, dass bereits ein Teil des Spülraums auf Grund der Konstruktion des Folienrahmens oder der Einrichtung ausgebildet ist und dieser Spülraum durch das Spülen weiter vergrößert wird. Dabei dichtet der Folienstempel den Spülraum von dem Bearbeitungsraum ab. Auf diese Weise ist ein besonders schonendes und fehlerfreies Prägen, insbesondere Nanoprägen, möglich.

In einer bevorzugten Ausführungsform des Verfahrens ist vorgesehen, dass ein Druckunterschied zwischen dem Druck des Bearbeitungsraumes und des Spülraums zwischen 0 und 800 mbar, bevorzugt zwischen 100 und 600 mbar, noch bevorzugter zwischen 200 und 600 mbar zum Bearbeiten, insbesondere zum Prägen, eingestellt wird. In anderen Worten wird der vorherrschende Druck im Bearbeitungsraum und der vorherrschende Druck im Spülraum so geregelt, dass eine gewünschte Prägekraft und Verformung des Folienstempels bewirkt wird. Ein Druckunterschied in den vorbezeichneten Bereichen hat sich dabei bei Versuchen als besonders vorteilhaft erwiesen.

In einer bevorzugten Ausführungsform des Verfahrens ist vorgesehen, dass das Substrat relativ zu Bearbeitungsmitteln der Einrichtung in dem ausgebildeten Bearbeitungsraum ausgerichtet wird. Die Bearbeitungsmittel können beispielsweise Prägemittel, Bond- oder Debondmittel oder sonstige Bearbeitungsmittel sein, bei welchen eine genaue relative Ausrichtung zum Substrat vorteilhaft ist. Dadurch das bei der Ausrichtung das Substrat relativ zu den Bearbeitungsmitteln der Einrichtung ausgerichtet wird, ist ein besonders genaues Ausrichten vor der Evakuierung möglich. Dabei ist auch ein indirektes Ausrichten des Substrats zu den Bearbeitungsmitteln durch eine Ausrichtung der Substrataufnahmeeinrichtung beziehungsweise der Einrichtung denkbar, wobei bevorzugt Ausrichtungsmarken verwendet werden.

In einer bevorzugten Ausführungsform des Verfahrens ist vorgesehen, dass die Ausrichtung des Substrats bei Normaldruck durchgeführt wird. In anderen Worten findet die Evakuierung erst nach der Ausrichtung des Substrats und nach der Ausbildung des Bearbeitungsraums statt. Dabei ist der Normaldruck der unter normalen Umständen in der Vorrichtung herrschende Druck. Wird die Vorrichtung bei Umgebungsdruck mit dem Substrat beladen, handelt es sich insbesondere um den herrschenden Atmosphärendruck. Dabei findet auch die Annäherung unter dem Normaldruck statt. Auf diese Weise kann das Verfahren zum Bearbeiten besonderes effizient durchgeführt werden. Zudem ist eine Ausrichtung besonderes genau bei Normaldruck durchführbar. In einer bevorzugten Ausführungsform des Verfahrens ist vorgesehen, dass das Substrat bei der Bearbeitung in Schritt e) freigegeben wird. Das Substrat kann dann mit bei der Bearbeitung im evakuierten Bearbeitungsraum frei mit Bearbeitungsmitteln interagieren. Auf diese Weise ist beispielsweise bei Prägeprozessen ein besonders gutes Bearbeitungsergebnis erzielbar.

In einer bevorzugten Ausführungsform des Verfahrens ist vorgesehen, dass die Bearbeitung in Schritt e) eine vollständige Kontaktierung des Substrats mit dem Folienstempel umfasst. Das Substrat wird somit in dem evakuierten Bearbeitungsraum mit dem Prägestempel geprägt beziehungsweise kontaktiert. Beispielsweise kann ein zuvor auf dem Prägestempel aufgebrachter Lack in Strukturen, vorzugsweise Nanostrukturen, auf dem Substrat aufgenommen werden oder eine bestimmte Struktur in das Substrat geprägt werden. Dabei ist der Prägestempel flexibel und kann sich besonders frei an das Substrat anlegen, so dass ein Prägen in dem evakuierten Bearbeitungsraum besonders genau und frei erfolgen kann. Dabei liegen das Substrat und der Prägestempel vollständig aneinander, so dass eine vollflächige Prägung ermöglicht wird.

In einer bevorzugten Ausführungsform des Verfahrens ist vorgesehen, dass der Folienstempel bei der Bearbeitung in Schritt e) nach einer vollständigen Kontaktierung mit dem Substrat zumindest teilweise freigegeben wird, so dass der Folienstempel an dem Substrat relaxieren kann. In dem lokalen und evakuierten Bearbeitungsraum wird somit der flexible Folienstempel nach der vollständigen Kontaktierung zumindest teilweise so angehoben oder bewegt, dass eine besonders freie Relaxation des Folienstempels an dem Substrat erfolgen kann. Dazu wird der Folienstempel vorzugsweise durch Spülmittel verformt beziehungsweise freigegeben. Die Spülmittel sind dabei insbesondere auf einer dem Substrat abgewandten Rückseite des Folienstempels angeordnet, so dass bei einer Spülung mit einem Fluid ein leichter Überdruck im Verhältnis, zu dem sonst im evakuierten Bearbeitungsraum herrschenden Druck entsteht, so dass der Folienstempel von einer Haltefläche losgelassen wird. Dabei muss der Folienstempel nicht an der Folienaufnahmeeinrichtung anliegen. Vorzugsweise wird durch die Spülmittel keine Flutung des gesamten Bearbeitungsbereiches durchgeführt, sondern lediglich im Bereich der Rückseite des Folienstempels ein kleiner Überdruck zur Freigabe des Folienstempels erzeugt. Auf diese Weise kann eine besonders genaue und schonende Prägung im Bearbeitungsraum erfolgen. In dieser Ausführungsform des Verfahrens zum Bearbeiten und Prägen ist vorgesehen, dass zwei Druckzonen vorhanden sind und diese durch den Folienstempel getrennt werden. Dabei ist der Bearbeitungsraum im Bereich der Rückseite des Folienstempels, insbesondere durch den Folienstempel selbst, von dem übrigen Bereich des Bearbeitungsraums fluidisch getrennt. Eine erste Druckzone wird durch die Ausbildung des Bearbeitungsraums, der evakuiert werden kann, definiert. Eine zweite Druckzone befindet sich im Bereich der Rückseite des Folienstempels (Spülzone). Diese zweite Druckzone kann durch Spülmittel geflutet werden.

In einer bevorzugten Ausführungsform des Verfahrens ist vorgesehen, dass ein Folienrahmen zur Aufnahme des Folienstempels weiterhin an der Einrichtung fixiert bliebt. Der Folienstempel ist vorzugsweise auf beziehungsweise an einem Folienrahmen fixiert beziehungsweise aufgespannt. Der Folienrahmen kann somit unabhängig von dem Folienstempel auf der Folienaufnahmeeinrichtung fixiert sein und bei einer Freigabe beziehungsweise Spülung vorteilhaft fixiert bleiben. Auf diese Weise bleibt der Folienstempel in einer bevorzugten Prägelage an dem Rahmen fixiert, wobei der Folienstempel sich trotzdem besonders gut an das Substrat anlegen kann. In anderen Worten kann der Folienstempel bei einer weiteren Fixierung des Rahmens besonders gut an dem Substrat relaxieren.

In einer bevorzugten Ausführungsform des Verfahrens ist vorgesehen, dass die Spülmittel bei dem Bearbeiten zusätzlich den Druck im Spülraum erhöhen, so dass eine Prägekraft zur Prägung des Substrats eingestellt werden kann. Dabei wird besonders bevorzugt der Druck im Bearbeitungsraum konstant gehalten. Dadurch kann der Folienstempel besonders gleichmäßig und schonend das Substrat kontaktieren bzw. Prägen. Somit kann der Folienstempel an dem Substrat relaxieren. Beim Prägevorgang wird das Füllen der Strukturen des Folienstempels durch Kapillarkräfte zusätzlich durch dem (leichten) Rückseitigen Überdruck im Spülraum unterstützt.

In einer bevorzugten Ausführungsform des Verfahrens ist vorgesehen, dass der Druckunterschied zwischen dem Druck des Bearbeitungsraums und dem Druck des Spülraums zur Entformung des Folienstempels von dem Substrat verwendet wird. Dabei wird vorzugsweise der Druck im Bearbeitungsraum konstant gehalten. In anderen Worten kann durch eine Verringerung des Drucks im Spülraum bzw. eine Evakuierung sich der Folienstempel vorteilhaft von der Prägemasse zurückziehen.

In einer bevorzugten Ausführungsform des Verfahrens ist vorgesehen, dass die Vorrichtung so eingerichtet ist, dass durch eine Druckregulierung des Drucks des Bearbeitungsraums und des Drucks des Spülraums eine Steuerung zum Prägen und Entformen automatisiert erfolgt. Der entstehende Druckunterschied zwischen den zwei Druckzonen wird zur Erzeugung von externen Kräften, die auf den Folienstempel wirken, beim Prägen und Entformen genutzt.

Weiterhin betrifft die Erfindung eine Vorrichtung zum Bearbeiten eines Substrats, zumindest aufweisend i) eine Substrataufnahmeeinrichtung zur Aufnahme des Substrats, ii) eine Einrichtung zum Bearbeiten des Substrats, iii) Mittel zur Ausbildung eines lokalen und fluidisch dichten Bearbeitungsraums zwischen der Substrataufnahmeeinrichtung und der Einrichtung, iv) Evakuierungsmittel zur Evakuierung des Bearbeitungsraums und v) Bearbeitungsmittel zur Bearbeitung des Substrats.

Die vorgenannten Vorteile und Merkmale des Verfahrens zum Nanoprägen eines Substrats gelten analog entsprechend für die Vorrichtung. Die Vorrichtung wird bevorzugt dazu eingerichtet, dass eine Evakuierung des ausbildbaren Bearbeitungsraumes durch die Evakuierungsmittel erst nach einer Ausrichtung durchführbar ist. Der Bearbeitungsraum ist dabei zumindest teilweise, bevorzugt vollständig, zwischen der Substrataufnahmeeinrichtung und der Einrichtung angeordnet.

Die Bearbeitungsmittel sind zumindest teilweise in dem Bearbeitungsraum angeordnet beziehungsweise können auf das Substrat in dem Bearbeitungsraum einwirken. Dabei ist der Bearbeitungsraum bei einer Bearbeitung evakuiert. Die Bearbeitungsmittel können insbesondere Mittel zum Prägen, Mittel zum Bonden- oder Debonden sowie Mittel zur Laserbearbeitung oder sonstige Mittel sein. Zudem können die Bearbeitungsmittel auch zumindest teilweise die Dichtmittel ausbilden. Auf diese Weise ist eine besonders effiziente Bearbeitung des Substrats in dem Bearbeitungsraum möglich.

Die Vorrichtung ist dabei vorzugsweise so ausgebildet, dass das Substrat freigebbar ist. Die Vorrichtung erlaubt somit eine besonders genaue Ausrichtung und Bearbeitung des Substrats in dem Bearbeitungsraum. Die Vorrichtung ist somit prädestiniert für eine effiziente und genaue Bearbeitung eines Substrats oder eines Substratstapels im Vakuum, insbesondere zum Nanoprägen von Substraten.

In einer bevorzugten Ausführungsform der Vorrichtung zum Bearbeiten von Substraten ist vorgesehen, dass die Mittel Annäherungsmittel zur Annäherung der Substrataufnahmeeinrichtung und der Einrichtung sind. In anderen Worten wird durch eine Relativbewegung der Einrichtung und/oder der Substrataufnahmeeinrichtung vorteilhaft schnell und direkt der Bearbeitungsraum ausgebildet. Auf diese Weise kann vorteilhaft ein lokaler Bearbeitungsraum zwischen den beiden Komponenten ausgebildet werden.

In einer bevorzugten Ausführungsform der Vorrichtung zum Bearbeiten von Substraten ist vorgesehen, dass die Vorrichtung zusätzlich Ausrichtungsmittel zur Ausrichtung der Substrataufnahmeeinrichtung und der Einrichtung zueinander aufweist, wobei die Ausrichtungsmittel so eingerichtet sind, dass vor und/oder während einem Wirken der Annährungsmittel die Substrataufnahmeeinrichtung und die Einrichtung zueinander ausrichtbar sind. Das Ausrichten kann dabei ebenfalls eine Justierung umfassen. Auf diese Weise kann präzise der Bearbeitungsraum ausgebildet werden. Zudem kann ein Ausrichten des Substrats zu den Bearbeitungsmitteln vorteilhaft gleichzeitig durch die Ausrichtungsmittel erfolgen. Eine Feinausrichtung des Substrats nach der Ausbildung des Bearbeitungsraums kann zusätzlich bei Bedarf erfolgen.

Dabei wird bei dem Ausrichten und/oder bei der Annäherung die Substrataufnahmeeinrichtung und die Einrichtung zueinander so ausgerichtet, dass eine optimale Bearbeitung und ein optimales Bearbeitungsergebnis ermöglicht ist. Insbesondere für Präge- oder Bondprozesse ist eine exakte Ausrichtung notwendig. Durch eine Ausrichtung der Substrataufnahmeeinrichtung und der Einrichtung zueinander, kann vorteilhaft auch das Substrat genau ausgerichtet beziehungsweise angeordnet werden.

Das Substrat wird in der Substrataufnahmeeinrichtung vorzugsweise mit Fixierelementen fixiert. Die Annäherung und die Ausrichtung erfolgen dabei beispielsweise durch Aktuatoren. Das Ausrichten und die Annäherung können auch in unterschiedlicher Reihenfolge durchgeführt werden. Auch ist denkbar, dass zunächst ausgerichtet und anschließend eine Annäherung der Substrataufnahmeeinrichtung und der Einrichtung durchgeführt wird. Nach der Annäherung und der Ausbildung des Bearbeitungsraums, kann zusätzlich eine Ausrichtung erfolgen. Auch eine parallele Durchführung der Annäherung und der Ausrichtung ist denkbar.

Durch die Annäherung der Substrataufnahmeeinrichtung und der Einrichtung wird ein lokaler und fluidisch dichter Bearbeitungsraum um das Substrat geschaffen. Dieser Bearbeitungsraum ist evakuierbar und zumindest teilweise zwischen beiden Aufnahmeeinrichtungen ausgebildet. Dabei kann der Bearbeitungsraum durch Dichtungen, welche vorzugsweise zumindest an der Substrataufnahmeeinrichtung angebracht sind, ausgebildet werden. Dabei kann auch jeweils ein Teil der Substrataufnahmeeinrichtung oder der Einrichtung die Dichtungen ausbilden. Bevorzugt wird ein Dichtring zur Abdichtung beziehungsweise Ausbildung des Bearbeitungsraumes verwendet. Sind die Dichtungen an der Substrataufnahmeeinrichtung und an der Einrichtung ausgebildet, handelt es sich bevorzugt um korrespondierende Dichtelemente.

Dadurch dass die Ausrichtung und Annäherung vor der Evakuierung durchgeführt wird, kann vorteilhaft eine Evakuierung danach erfolgen, wobei Ausrichtungsfehler vermieden werden. Zudem kann vorteilhaft lediglich der lokale Bearbeitungsraum evakuiert werden. Eine Evakuierung der Vorrichtung oder des gesamten Moduls ist somit nicht notwendig. Auf diese Weise ist eine besonders schnelle und effiziente Bearbeitung des Substrats möglich.

In einer bevorzugten Ausführungsform der Vorrichtung zum Bearbeiten von Substraten ist vorgesehen, dass die Substrataufnahmeeinrichtung und die Einrichtung korrespondierende Dichtmittel aufweist, wobei die Annährungsmittel so eingerichtet sind, dass nach dem Wirken der Annäherungsmittel die korrespondierenden Dichtungsmittel den Bearbeitungsraum zwischen der Substrataufnahmeeinrichtung und der Einrichtung ausbilden. In anderen Worten wird ein Teil des Bearbeitungsraums durch die Dichtungsmittel gebildet. Die Dichtmittel können dabei so ausgebildet sein, dass beispielsweise ein Ineinandergreifen an mehreren Stellen möglich ist, so dass auf diese Weise vorteilhaft gleichzeitig das Substrat zu den Bearbeitungsmitteln ausgerichtet werden kann. Der Bearbeitungsraum kann somit vorteilhaft in unterschiedlichen Positionen der Einrichtung und der Substrataufnahmeeinrichtung ausgebildet werden.

In einer bevorzugten Ausführungsform der Vorrichtung zum Bearbeiten von Substraten ist vorgesehen, dass die Mittel steuerbare Abdichtungsmittel zur Ausbildung des Bearbeitungsraums zwischen der Substrataufnahmeeinrichtung und der Einrichtung sind. Somit findet keine unmittelbare Annäherung der Einrichtung und der Substrataufnahmeeinrichtung statt. Vielmehr wird durch die Abdichtungsmittel der Raum zwischen der Einrichtung und der Substrataufnahmeeinrichtung abgedichtet und somit der Bearbeitungsraum ausgebildet. Auf diese Weise kann vorteilhaft schnell und effizient der Bearbeitungsraum ausgebildet werden. Zudem kann ein Ausrichten der Substrataufnahmeeinrichtung und der Einrichtung zueinander weggelassen werden oder vorab erfolgen.

In einer bevorzugten Ausführungsform der Vorrichtung zum Bearbeiten von Substraten ist vorgesehen, dass die Substrataufnahmeeinrichtung und die Einrichtung einteilig ausgebildet sind. Dadurch wird eine besonders kompakte Bauform der Vorrichtung ermöglicht. Zudem kann durch die einteilige Ausführung eine Ausrichtung von dem Substrat zu den Bearbeitungsmitteln entfallen oder bereits beim Beladen der Vorrichtung mit dem Substrat, vorzugsweise durch ein Einschieben des Substrats von der Seite bzw. parallel zur Aufnahmefläche der Substrataufnahmeeinrichtung, erfolgen. Somit werden Positionsfehler vermieden und ein Bearbeitungsraum mit besonders geringem Volumen zur effizienten Ausbildung eines Vakuums bereitgestellt.

In der Vorrichtung zum Bearbeiten von Substraten ist vorgesehen, dass die Bearbeitungsmittel einen flexiblen Folienstempel zum Nanoprägen des Substrats aufweisen. Ein flexibler Folienstempel ist dabei für den Einsatz in der Vorrichtung prädestiniert. Der Folienstempel kann dabei in einem Folienrahmen bereitgestellt werden. Besonders bevorzugt bildet der Folienstempel einen Teil des Bearbeitungsraums bzw. einen äußeren Rand.

In der Vorrichtung zum Bearbeiten von Substraten ist vorgesehen, dass die Vorrichtung zusätzlich Spülmittel zur Ausbildung eines fluidisch dichten Spülraums zwischen der Einrichtung und dem Folienstempel aufweist, wobei der Spülraum fluidisch durch den Folienstempel von dem Bearbeitungsraum getrennt ist, und wobei der Folienstempel durch die Spülmittel gezielt verformbar ist. Die Spülmittel sind beispielsweise Ventile über welche der Spülraum geflutet oder evakuiert werden kann. In anderen Worten kann der Druck durch die entsprechende Fluidmenge, auf der dem Bearbeitungsraum abgewandten Seite des Folienstempels, eingestellt werden, so dass der Folienstempel gezielt verformt bzw. in Richtung des Substrats gekrümmt werden kann. Der Spülraum wird dabei zumindest teilweise durch den Folienstempel ausgebildet. Dabei kann die Einrichtung selbst oder auch teilweise ein Folienrahmen ebenfalls den Spülraum definieren. Der Folienstempel kann dabei zunächst mit der dem Bearbeitungsraum abgewandten Seite an der Einrichtung oder einem Folienrahmen anliegen, so dass erst durch das Einbringen eines Fluids durch die Spülmittel der Spülraum ausgebildet wird. Ebenfalls ist denkbar, dass bereits ein Teil des Spülraums durch die Geometrie der Einrichtung und/oder des Folienrahmens bereitgestellt wird. In diesem Fall wird durch die Spülmittel der Spülraum vergrößert, wobei der Folienstempel in Richtung des Substrats verformt wird. Auf diese Weise ist eine besonders schonende und fehlerfreie Prägung möglich.

In einer bevorzugten Ausführungsform der Vorrichtung zum Bearbeiten von Substraten ist vorgesehen, dass die Vorrichtung so eingerichtet ist, dass ein Druckunterschied zwischen dem Druck des Bearbeitungsraumes und des Spülraums zwischen 0 und 800 mbar, bevorzugt zwischen 100 und 600 mbar, noch bevorzugter zwischen 200 und 600 mbar einstellbar ist. In anderen Worten wird eine Druckdifferenz in den vorbezeichneten Bereichen eingestellt, um die Verformung und eine Prägekraft gezielt einzustellen. Dabei wird die Druckdifferenz vorzugsweise in Abhängigkeit eines konstanten Drucks im Bearbeitungsraum durch die Spülmittel geregelt. Auf diese Weise kann vorteilhaft durch die Spülmittel der Prägevorgang initiiert werden.

In einer bevorzugten Ausführungsform der Vorrichtung zum Bearbeiten von Substraten ist vorgesehen, dass die Spülmittel gleichzeitig Evakuierungsmittel sind, so dass der Folienstempel von dem Substrat durch Evakuierung des Spülraums entformbar ist. In anderen Worten kann durch ein Evakuieren des Spülraums durch die Spülmittel die Prägekraft reduziert bzw. die Verformung während dem Prägen reduziert werden. Auf diese Weise kann vorteilhaft schonend eine Entformung des Folienstempels vom Substrat bzw. einer darauf bereitgestellten Prägemasse nach dem Prägen durchgeführt werden.

Der Druck in dem Bereich der Rückseite des Folienstempels bzw. in dem Spülraum wird zwischen 1 mbar und 1500 mbar eingestellt, bevorzugt zwischen 1100 mbar und 1250 mbar.

In einer bevorzugten Ausführungsform wird nach dem Ausrichten ein Grob-Vakuum zwischen dem Folienstempel und dem Substrat in dem Bearbeitungsraum eingestellt.

Bei der Evakuierung ist der Druck in dem Prägeraum kleiner als 500 mbar, mit Vorzug kleiner als 300 mbar, mit größtem Vorzug kleiner als 250 mbar.

Insbesondere wird bevorzugt Grobvakuum zwischen 300 mbar und 1 mbar eingestellt, am bevorzugtesten zwischen 250 mbar und 100 mbar. In einer bevorzugten Ausführungsform wird, zusätzlich zum Grob-Vakuum im Bearbeitungsraum, während und/oder nach der (vollflächigen) Kontaktierung zwischen Folienstempel und dem mit Prägemasse beschichteten Substrat der Druck im Bereich der Rückseite des Folienstempels (Spülzone) bevorzugt zwischen 1100 mbar und 1250 mbar eingestellt.

Der Druckunterschied zwischen dem Bearbeitungsraum und dem Bereich der Rückseite des Folienstempels (Spülzone) bzw. des Spülraums wird auch zur Entformung des Folienstempels von der Prägemasse verwendet. Beispielsweise wird dafür der Druck im Bearbeitungsraum auf Normaldruck eingestellt während der Druck im Bereich der Rückseite des Folienstempels (Spülzone) zwischen 1100 mbar und 1500 mbar eingestellt wird.

In einer bevorzugten Ausführungsform der Vorrichtung zum Bearbeiten von Substraten ist vorgesehen, dass der Druckunterschied zwischen dem Bearbeitungsraum und der Rückseite des Folienstempels zur aktiven Steuerung der Prägung und der Entformung verwendet wird. Dadurch werden externe Kräfte erzeugt, die zum Bearbeiten des Substrats genutzt werden. Der Bereich der erzeugten Kräfte, insbesondere Prägekräfte liegt bevorzugt zwischen 100 N und 10 kN.

In einer bevorzugten Ausführungsform der Vorrichtung zum Bearbeiten von Substraten ist vorgesehen, dass der Bearbeitungsraum zwischen der Substrataufnahmeeinrichtung und der Einrichtung im Bereich des Substrates ausbildbar ist, so dass das Substrat vollständig innerhalb des Bearbeitungsraums anordbar ist. Auf diese Weise können insbesondere handelsübliche Wafer oder sonstige Halbleiterelemente in dem Bearbeitungsraum effizient bearbeitet werden.

In einer Ausführungsform der Vorrichtung zum Bearbeiten von Substraten ist vorgesehen, dass die Bearbeitungsmittel Mittel zum Bonden, vorzugsweise zum Bonden von flexiblen Substraten und/oder Folien-Substrate, die auf Film Frames fixiert sind, umfassen. Auf diese Weise ist eine besonders effiziente Bearbeitung des Substrats in dem Bearbeitungsraum durch flexibles Fügen und Kontaktieren beim Bonden möglich. Beispielsweise können elektronische und/oder optische Bauelemente, insbesondere Chips (engl: die), die auf einem dünnen (Träger-)Substrat aufgebracht sind, mit einem zweiten Substrat, insbesondere ein Wafer, gebondet werden (engl.: Chip-to-Wafer Bonding).

In einer bevorzugten Ausführungsform der Vorrichtung zum Bearbeiten von Substraten ist vorgesehen, dass die Bearbeitungsmittel Prägemittel, vorzugsweise einen flexiblen Prägestempel, zum Prägen des Substrats umfassen. Die Vorrichtung ist dabei für ein besonders genaues und effizientes Prägen im Vakuum prädestiniert. Der flexible Prägestempel ist dabei ein weicher Stempel. Der Prägestempel kann dabei selbst Strukturen aufweisen, welche auf das Substrat übertragen werden beziehungsweise auf dem Substrat abgeformt werden. Zudem kann der flexible Prägestempel auch Lacke oder sonstige Materialien auf das Substrat aufbringen. Insbesondere im Vakuum ist das Prägen mit Prägemitteln besonderes genau und effizient durchführbar. Dabei weisen die Prägemittel und/oder das Substrat besonders bevorzugt Mikro- beziehungsweise Nanostrukturen auf, so das vorteilhaft besonders kleine Strukturen erzeugbar beziehungsweise prägbar sind.

In einer bevorzugten Ausführungsform der Vorrichtung zum Bearbeiten von Substraten ist vorgesehen, dass die Einrichtung eine Folienstempelaufnahmeeinrichtung ist, und wobei die Prägemittel einen Folienstempel umfassen. Die Folienstempelaufnahmeeinrichtung ist besonders geeignet um in der Vorrichtung als Einrichtung verwendet zu werden, da ein aufgenommener Folienstempel besonders genau die Strukturierung des Substrates in dem evakuierten Bearbeitungs- beziehungsweise Prägeraum vornehmen kann.

In einer bevorzugten Ausführungsform der Vorrichtung zum Bearbeiten von Substraten ist vorgesehen, dass die Folienstempelaufnahmeeinrichtung einen an der Folienaufnahmeeinrichtung fixierbaren Rahmen zur Aufnahme des Folienstempels aufweist. Der Rahmen nimmt dabei den Folienstempel in einem auf und wird vorzugsweise durch Fixiermittel der Folienaufnahmeeinrichtung an dieser fixiert. Somit ist eine vorteilhafte indirekte und flexible Anordnung des Folienstempels an der Folienaufnahmeeinrichtung vorgebbar. Auf diese Weise ist ein besonders gutes Bearbeitungs- beziehungsweise Prägeergebnis erzielbar. Zudem kann bei einem freigegebenen Substrat dieses besonders gut in einer Position zum Prägen an dem Folienstempel anliegen. Dabei wird das Substrat vorzugsweise von Kapillarkräften an dem in dem Rahmen befestigten Folienstempel gehalten.

In einer bevorzugten Ausführungsform der Vorrichtung zum Bearbeiten von Substraten ist vorgesehen, dass durch Spülmittel der Folienstempel zumindest teilweise in dem Bearbeitungsraum freigebbar ist. In anderen Worten ist auf der Rückseite des Folienstempels in Bereich der Haltfläche der Folienaufnahmeeinrichtung zumindest ein Spülmittel vorhanden, welches eine teilweise Flutung des Bearbeitungsraums beim Bearbeiten beziehungsweise Prägen ermöglicht. Der in dem Rahmen festgehaltene Folienstempel ist somit vorteilhaft zumindest teilweise freigebbar. Somit kann der Folienstempel durch ein gezieltes Fluten auf der Rückseite des Folienstempels angehoben und somit freigegeben werden, so dass ein besonders gutes Anlegen beziehungsweise Relaxieren an dem Substrat in dem Bearbeitungsraum erfolgen kann. Dabei ist der Bearbeitungsraum im Bereich der Rückseite des Folienstempels, insbesondere durch den Folienstempel selbst, von dem übrigen Bereich des Bearbeitungsraums fluidisch getrennt. Der Rahmen bleibt bei einem Spülen mit den Spülmitteln besonders bevorzugt fixiert, so dass die Position des Folienstempels zum Substrat vorteilhaft vorgebbar ist.

In einer bevorzugten Ausführungsform der Vorrichtung zum Bearbeiten von Substraten ist vorgesehen, dass der Bearbeitungsraum zumindest teilweise durch den Rahmen ausgebildet ist. In anderen Worten stellt eine Begrenzung des Bearbeitungsraums der Rahmen dar. Besonders bevorzugt werden dabei zumindest teilweise die Dichtmittel durch den Rahmen ausgebildet. Auf diese Weise ist der lokale und fluidisch dichte Bearbeitungsraum besonders einfach bereitstellbar.

In einer bevorzugten Ausführungsform der Vorrichtung zum Bearbeiten von Substraten ist vorgesehen, dass die Dichtungsmittel so an der Substrataufnahmeeinrichtung und/oder der Folienaufnahmeeinrichtung angeordnet sind, dass der Rahmen vollständig innerhalb des Bearbeitungsraums anordbar ist. In anderen Worten sind die Dichtmittel außerhalb, insbesondere im Bereich der Peripherie der Aufnahmeeinrichtungen angeordnet. Somit kann eine besonders vorteilhafte Anordnung des Rahmens und des Folienstempels vollständig in dem Bearbeitungsraum erfolgen.

Ein besonders wichtiger Aspekt ist es, dass durch das Verfahren und die Vorrichtung zum Bearbeiten ein Nanoprägen mir sehr präzisem Overlay Alignment ermöglicht werden. Dabei ist es vorteilhaft möglich den Kontakt zwischen Substrat und Stempel bestmöglich zu kontrollieren. Das Füllverhalten von Nanostrukturen, insbesondere mit geringem residual Layer, ist am besten mit flexiblen Stempeln, die sich auf dem Substrat relaxieren können, möglich. Insbesondere ist ein kontrolliertes Kontaktieren beziehungsweise Prägen trotz der weichen und flexiblen Prägemittel möglich.

Bei der Idee wird der Stempel zuerst fixiert und ausgerichtet, dann ein Vakuum zwischen Substrat und Stempel eingebracht, um Lufteinschlüsse zu verhindern, und dann der Kontakt über kontrolliertes Verbiegen des Substrats und/oder des Stempels und/oder Initiieren einer Prägewelle hergestellt. Das Verfahren beziehungsweise die Methode ermöglicht das effiziente Nanoprägen im Vakuum mit genauer Kontrolle der Oberflächenkontaktierung für flexible Stempel.

Zudem ist eine besonders genaue Kontrolle bei der Kontaktierung des Stempels und dem Substrat möglich, wobei die Steifigkeit des Substrats gleichzeitig eine hochgenaue Ausrichtung zueinander erlaubt.

Vorteilhaft an dem Verfahren und der Vorrichtung ist unter anderem auch, dass nicht auf einen flexiblen Stempel verzichtet werden muss.

Weiterhin müssen nicht die gesamten Aufnahmeeinrichtungen ins Vakuum geladen und justiert werden.

Somit ist trotz Vakuum ein schnelleres kontaktieren als mit SmartNIL (WO2014/037044A1) und somit ein höherer Durchsatz möglich.

Ein besonders wichtiger Aspekt ist das Prägen im Vakuum mit einem flexiblen Folienstempel, wobei die Ausrichtung von Stempel und Substrat bei Normaldruck stattfindet und wobei ein lokal evakuierbarer Prägeraum zwischen der oberen und der unteren Aufnahmeeinrichtung bei ausreichender Annäherung der Aufnahmeeinrichtungen entsteht, der ein vereinfachtes Kontaktieren und Prägen im Vakuum ermöglicht, wobei der Kontakt zwischen Substrat und Stempelfolie über kontrolliertes Verbiegen des Substrats und/oder des Folienstempels und Initiierung einer Prägewelle hergestellt wird. Dadurch ist ein Nanoprägen mit sehr präzisem Overlay Alignment und ohne Lufteinschlüsse mit Folienstempeln möglich.

Im weiteren Verlauf werden die Worte Stempel, Folienstempel, Prägestempel sowie Nanostrukturstempel synonym verwendet. Zudem wird im Folgenden mit einer Strukturierung und einer Prägung das Erzeugen der Mikro- und/oder Nanostrukturen gemeint.

Ein weiterer wichtiger Aspekt ist die Kontaktierung, wobei durch Vorspannung des Substrats und/oder des Folienstempels zunächst nur eine Teilfläche kontaktiert wird und anschließend, ein selbsttätiges Kontaktieren der Kontaktflächen bewirkt wird, wobei bevorzugt die gesamte Substratfläche ohne Wiederholen der vorgenannten Schritte in einem lokal mit Dichtungen abgegrenzten Prägeraum im Vakuum mit einem dünnen, flexiblen Folienstempel geprägt wird.

Ein weiterer besonders wichtiger Aspekt ist, dass die Ausrichtung von Substrat und Folienstempel zuerst unter Normaldruck stattfindet. Erst danach entsteht nach ausreichender Annäherung der oberen und der unteren Aufnahmeeinrichtung und durch Kontaktierung über Dichtungen ein lokal begrenzter Prägeraum der aktiv evakuiert wird. Dabei werden Substrat und Folienstempel zuerst fixiert und ausgerichtet, dann im Prägeraum Vakuum zwischen Substrat und Folienstempel eingebracht um Lufteinschlüsse zu Verhindern und anschließend der Kontakt zwischen dem zu prägenden Substrat und dem Folienstempel über kontrolliertes Verbiegen des Substrats und Initiierung einer Prägewelle hergestellt.

Die Prägefront wird insbesondere mit einem Aktuator im Zentrum gestartet. Durch das Ausbreiten der Prägefront wird die strukturierte Stempeloberfläche im aushärtbaren Material, insbesondere Resist-Lack, auf dem Substrat eingedrückt und die Strukturen des Folienstempels werden repliziert. Der Prozess kann bevorzugt zum Prägen einer ersten Schicht oder einer zweiten Lage in Kombination mit exakter Justage (SmartView Alignment) eingesetzt werden.

Die Belackung des Stempels und/oder des Substrats kann wahlweise vom Prägeprozess getrennt in einem eigenen Modul durchgeführt werden.

Ein wesentlicher Vorteil ist, dass die Ausrichtung bei Umgebungsdruck stattfindet und danach die vollflächig belackten Substrate im Vakuum defektfrei kontaktiert und geprägt werden können. Dadurch entfallen die, durch die Bewegung der Substrate entstehenden, Positionierungsfehler, die insbesondere in einer evakuierbaren Umgebung auftreten können. Durch den lokal begrenzten Prägeraum ist eine relativ schnelle Evakuierung möglich im Vergleich zu Anlagen, in welchen das gesamte Prägemodul evakuiert werden muss.

Für das Prägen mir flexiblen Stempeln im Vakuum werden Folienrahmen oder auch andere Stempelhalter mit Rahmen verwendet. Der Rahmen kann auch genutzt werden, um die Vakuumzone beziehungsweise den evakuierbaren Prägeraum zu definieren. In einer bevorzugten Ausführungsform wird nur (Grob-)Vakuum zwischen dem Folienstempel und dem Substrat in einem Prägeraum eingestellt sodass nicht das ganze Präge-Modul evakuiert werden muss.

Vor dem Prägen werden Substrat und Stempel möglichst genau zueinander ausgerichtet werden. Die Ausrichtung erfolgt dabei meistens über Ausrichtungsmarken.

Die Basis-Anlage kann insbesondere durch ein EVG SmartView System bereitgestellt werden, wobei es nicht notwendig ist zwischen Substrat und Folienstempel zu sehen, weil der Folienstempel vorzugsweise überwiegend transparent ist. Somit wird ein Ausrichten vorteilhaft nicht durch den Folienstempel verhindert, da Ausrichtungsoptiken durch den Folienstempel hindurchsehen können.

Die Prägeeinrichtung besteht insbesondere aus einer Stempelaufnahmeeinrichtung und einer Einrichtung zur Aufnahme eines Nanostrukturstempels. Der Nanostrukturstempel, insbesondere ein Folienstempel, wird vorzugsweise in einem Folienrahmen gespannt.

Eine Erfassungseinrichtung sorgt gemäß einer vorteilhaften Ausführungsform für die exakte Ausrichtung von Substrat und Folienstempel, indem sie die relativen Positionen erfasst, an die Steuerungseinheit weitergibt, welche dann eine Ausrichtung von Substrat und Folienstempel zueinander bewirkt.

Die Anlage verfügt vorzugsweise über ein System für einen kontaktlosen Keilfehlerausgleich zwischen den parallel ausgerichteten Folienstempel und Substrat, wie ausführlich in der WO2012/028166A1 beschrieben und referenziert.

Eine große Herausforderung beim Prägen besteht beim Prägevorgang selbst, also während der Initiierung der Prägewelle nach der punktförmigen, mittigen, Kontaktierung bis zur vollständigen Kontaktierung der Kontaktflächen von Substrat und Folienstempel. Hierbei kann sich die Ausrichtung zueinander gegenüber der vorherigen Ausrichtung noch maßgeblich ändern. Für das Nanoprägen mir sehr präzisem Overlay Alignment ist es notwendig den Kontakt zwischen Substrat und Folienstempel bestmöglich zu kontrollieren. Besonders kritisch ist das Ablegen/Kontaktieren von Substrat und Folienstempel, da hier Fehler auftreten können, wobei sich die Fehler addieren können.

Bei dem kritischen Schritt der Kontaktierung der ausgerichteten Kontaktflächen von Substrat und Folienstempel ist eine immer exaktere Justiergenauigkeit beziehungsweise Offset gewünscht. Der Ausrichtungsfehler beträgt weniger als 100 µm, insbesondere weniger als 10 µm, vorzugsweise weniger als 1 µm, mit aller größtem Vorzug kleiner als 100 nm, am bevorzugtesten weniger als 10 nm.

Das Kontaktieren der Kontaktflächen und Prägen der korrespondierenden Oberflächen mittels der Einrichtungen erfolgt insbesondere an einer Prägeinitiierungsstelle. Das Nanoimprint-Prägen des Substrats mit dem Folienstempel erfolgt entlang einer von der Prägeinitiierungsstelle zu Seitenrändern des Folienstempels verlaufenden Prägefront durch Loslösen des Substrats und/oder des Folienstempels von der Aufnahmefläche.

Die Geschwindigkeit der Prägewelle kann auch durch kontrolliertes Loslösen des Substrats und/oder des Folienstempels gesteuert werden. Bevorzugt werden die Fixierelemente in getrennt steuerbare Zonen aufgeteilt. Bevorzugt wird eine Vakuum-Fixierung verwendet.

Ein Stift in der zentrischen Bohrung oder eine Leitung, aus dem ein Überdruck, durch ein eingeleitetes Gas, zwischen der Substrataufnahmeeinrichtung und dem Substrat erzeugt werden kann, dienen der steuerbaren Durchbiegung des fixierten Substrats (Krümmungsmittel und/oder Krümmungsänderungsmittel). Weitere Verformungsmittel wie die Beaufschlagung mit einem Fluid sind denkbar.

In einer weiteren Ausführungsform dienen ein Stift in der zentrischen Bohrung oder eine Leitung, aus dem ein Überdruck, durch ein eingeleitetes Gas, zwischen der Folienstempel-Aufnahmeeinrichtung und dem Folienstempel erzeugt werden kann, der steuerbaren Durchbiegung des fixierten Folienstempels (Krümmungsmittel und/oder Krümmungsänderungsmittel).

Vorspannung und Kontaktierung an der Prägeinitiierungsstelle werden ausführlich in der WO2015/161868A1 beschrieben und referenziert. Auf dessen genaue Beschreibung wird daher hier verzichtet.

In einer ersten Ausführungsform wird das Substrat an der oberen Aufnahmeeinrichtung fixiert und nach der Kontaktierung einerseits durch die Schwerkraft und andererseits bedingt durch eine entlang der Prägewelle und zwischen Substrat und Stempel wirkende Kraft kontrolliert nach unten gezogen. Es kommt so zu einer Ausbildung einer radialsymmetrischen Prägewelle, die insbesondere vom Zentrum zum Seitenrand verläuft. Die Ausbildung einer Prägewelle ist nicht auf einer radialsymmetrischen Prägewelle eingeschränkt. In einer alternativen Ausführungsform ist die Ausbildung einer linearen Prägewelle erwünscht. Dafür findet die Kontaktierung am Substratrand statt und die lineare Prägefront breitet sich vom Randpunkt weg.

In einer zweiten, bevorzugten, Ausführungsform wird das Substrat an der unteren Aufnahmeeinrichtung fixiert. Bei der Vorspannung und Kontaktierung an der Prägeinitiierungsstelle werden nur die Fixiermittel im Randbereich der Substrataufnahmeeinrichtung eingesetzt. Sobald das Substrat in Kontakt mit dem Folienstempel ist, wird die Fixierung vom mit Prägemasse beschichteten Substrat durch Unterbrechung des Vakuums gelöst. Durch Reduzierung des Unterdrucks an der Aufnahmefläche kann das Ablösen vom Substrat kontrolliert durchgeführt werden. Entsprechend werden die Fixierelemente gesteuert. Der Folienstempel bleibt unverändert an der Stempelaufnahmeeinrichtung fixiert.

In einer dritten, bevorzugten Ausführungsform wird das Substrat an der unteren Aufnahmeeinrichtung fixiert und der an der oberen Aufnahmeeinrichtung fixierten Folienstempel wird für die Kontaktierung von Substrat und Folienstempel durch Verformungsmittel durchgebogen. Der Abstand zwischen Substrat und Folienstempel wird zuerst auf einen genau definierten Abstand reduziert, bevor der Prägeprozess gestartet wird. Bei dem Prägeverfahren werden Substrat und Folientempel nicht plan aufeinandergelegt, sondern zuerst in einem Punkt z.B. der Mitte M des Substrats oder ein Randpunkt R des Substrats miteinander in Kontakt gebracht, indem der Folienstempel durch Verformungsmittel leicht gegen das Substrat gedrückt und dabei verformt wird. Nach dem Loslösen des verformten i.e. durchgebogenen Folienstempels (in Richtung des gegenüberliegenden Substrats) erfolgt durch das Voranschreiten einer radialsymmetrischen oder linearen Prägewelle ein kontinuierliches und gleichmäßiges Prägen entlang der Prägefront.

Ein weiteres eigenständiges Merkmal der vorgeschlagenen Erfindung ist, dass nach dem vollflächigen Kontakt zwischen Folienstempel und Substrat der flexible Folienstempel durch einen leichten rückseitigen Überdruck mittels Spülventile "losgelassen" wird, während der Folienrahmen fixiert verbleibt. Somit kann der Folienstempel auf dem Substrat relaxieren. Durch die Kapillarkräfte werden die Strukturen gefüllt und durch die zu diesem Zeitpunkt gegebene Flexibilität kann sich der Folienstempel konform der Substratoberfläche anpassen. Damit kann eine hochauflösende Oberflächenstrukturierung durchgeführt werden. Dabei wird die Spülung beziehungsweise Druckerhöhung im Bereich der Rückseite des Folienstempels (Spülzone) - bei gleichbleibendem Druck beziehungsweise Vakuum im Bearbeitungsraum - zum relaxieren des Folienstempels an dem Substrat aber auch gleichzeitig für eine gleichmäßige Kraftaufbringung beim Prägen verwendet. Beim Prägevorgang wird das Füllen der Strukturen des Folienstempels durch Kapillarkräfte zusätzlich mit dem (leichten) Rückseitigen Überdruck unterstützt. Dadurch wird vorteilhaft die Prägezeit verkürzt.

Um die Ausrichtungsgenauigkeit möglichst hochzuhalten ist in einer ersten Ausführungsform vorgesehen, dass der Imprint extern ausgehärtet und entformt wird. Nach dem Prägevorgang im Ausrichtungs- und Präge-Modul wird somit der Stapel auf eine Unload-Station transferiert und anschließend im Aushärte- und Ablöse-Modul der Lack durch den transparenten Folienstempel mittels elektromagnetischer Strahlung, insbesondere UV-Licht, vernetzt. In einer zweiten Ausführungsform finden die Aushärtung und die Entformung auch im Präge-Modul statt. Somit ist nur ein Modul notwendig für Ausrichtung, Prägung, Aushärtung und Entformung, wodurch die Prozesszeiten optimiert werden können.

Das verwendete UV-Licht ist wahlweise breitbandiges Licht oder speziell abgestimmt auf den verwendeten Photoinitiator im Prägelack. Der Wellenlängenbereich des aushärtbaren Materials liegt insbesondere zwischen 50 nm und 1000 nm, vorzugsweise zwischen 150 nm und 500 nm, mit größerem Vorzug zwischen 200 nm und 450 nm.

Die Prägemasse kann in einer alternativen Ausführungsform auch thermisch ausgehärtet werden. Eine thermische Aushärtung erfolgt zwischen 0°C und 500°C, vorzugsweise zwischen 50°C und 450°C, noch bevorzugter zwischen 100°C und 400°C, am bevorzugtesten zwischen 150°C und 350°C, am allerbevorzugtesten zwischen 200°C und 300°C.

Am Ende des Verfahrens wird der Folienstempel insbesondere vom Substrat abgezogen und das Substrat entladen. Die Anlage verfügt vorzugsweise über Sensoren zur Kraftüberwachung für eine Kontrolle des Entformungsschrittes.

In einer beispielhaften Ausführungsform des Verfahrens zum Bearbeiten beziehungsweise zum Prägen eines Substrats mit einem flexiblen Folienstempel weist in einer allgemeinen Ausführungsform insbesondere folgende Schritte auf, bevorzugt in der folgenden Reihenfolge:
a) Substrat-Beschichtung bzw. Belackung mittels einer Aufbringeinrichtung z.B. einer Spinbelackungsanlage,
b) Justierung von Substrat und Folienstempel mittels einer Justiereinrichtung bei Normaldruck,
c) Annäherung der oberen und/oder der unteren Aufnahmeeinrichtung bis zur Bildung des evakuierbaren Prägeraums durch Abdichtung,
d) Evakuierung/Ausbilden des Vakuums im definierten Prägeraum zwischen Folienstempel und Substrat,
e) Prägen des Substrats im Vakuum mit Start des Imprintvorgangs durch einen Aktuator am Substrat und/oder am Folienstempel und Prägewelle,
f) Loslösen der Substrat-Fixierung,
g) Gas-Spülung hinter dem Folienstempel für Folien-Relaxation und Steuerung des Prägevorgang,
h) UV-Belichtung des aushärtbaren Materials und
i) Entformen von Folienstempel und Substrat, insbesondere durch Evakuierung des Spülraums durch die Spülmittel.

Ist die Vorrichtung zum Bearbeiten von Substraten im Zusammenhang mit Mittel zum Bonden offenbart, umfasst Punkt a) allgemeiner mögliche Vorprozesse wie beispielsweise Reinigung, Oberflächenaktivierung, Imprinten etc.

Die Vorrichtung zum Bearbeiten ist bevorzugt im Zusammenhang mit der Erzeugung beziehungsweise Prägung von Mikro- und/oder Nanostrukturen offenbart. Ein Substrat ist insbesondere mit einer Prägemasse auf einer Substrataufnahmeeinrichtung fixierbar und ein Strukturstempel mit der Prägemasse kontaktierbar. Dabei ist die Fixierung des Substrates zumindest teilweise aufhebbar und die Prägemasse aushärtbar, wobei die Prägemasse von dem Strukturstempel entformbar ist.

Der Stempel ist besonders bevorzugt ein Imprintstempel zur Verwendung in der Imprint-Technologie. Der Stempel ist bevorzugt als Weichstempel zum Imprinten von Substraten ausgebildet. Der Stempel wird bevorzugt mit einer Rückplatte (Backplane) in Serie ausgebildet, wobei Stempel und Rückplatte im Allgemeinen aus unterschiedlichen Materialien bestehen können. Die Verwendung mehrerer unterschiedlicher Materialien führt dazu, dass die daraus hergestellten einzelnen oder zusammengesetzten Stempel als Hybridstempel bezeichnet werden. Die Rückplatte kann dabei als Versteifung des Stempels dienen. bevorzugt sind allerdings Rückplatten, die sehr flexibel sind und nur als Träger für den Stempel dienen.

Die Rückplatte kann beispielsweise eine Folie sein oder aus Glas sein. Bevorzugt besteht die Rückplatte aus einer Folie. Die Rückplatte hat dann insbesondere eine Dicke, die geringer ist als 1000 µm, mit Vorzug geringer als 500 µm, mit größerem Vorzug geringer als 250 µm, mit größtem Vorzug geringer als 100 µm.

In einer anderen Ausführungsform ist vorgesehen, dass die Rückplatte eine sehr dünne und flexible Glasplatte ist. Die Glasplatte ist insbesondere dünner als 10 mm, vorzugsweise dünner als 5 mm, noch bevorzugter dünner als 1 mm, am bevorzugtesten dünner als 500 µm, am allerbevorzugtesten dünner als 100 µm, am höchsten bevorzugt dünner als 10 µm.

Insbesondere werden technische Gläser bevorzugt mit angepasstem Wärmeausdehnungskoeffizienten (CTE coefficient of thermal expansion).

Eine spezielle Art von Weichstempel sind die Folienstempel, die aus einer dünnen Folie bestehen, auf die Mikro- und/oder Nano-Prägestrukturen aufgebracht werden. Folie und Prägestrukturen bilden den Weichstempel. Dabei werden Hartstempel als Masterstempel zur Erzeugung des Weichstempels als Negativ vom Hartstempel verwendet. Die Prägemasse für die Stempelherstellung befindet sich auf der Folie, die als Rückplatte dient. Nach der Ablösung des Masterstempels von der ausgehärteten Prägemasse verbleibt der erzeugte Stempel vorzugsweise auf der Rückplatte, insbesondere auf der Folie.

Der Weichstempel besteht insbesondere aus einem der folgenden Materialien:
- Thermoplast,
- Elastomer und/oder
- Duroplast.

Der Folienstempel besteht insbesondere aus mindestens einem der folgenden Materialien:
- Poly(organo)siloxane (Silikon), insbesondere
   Polyhedrales oligomerisches Silsesquioxan (POSS) und/oder
   Polydimethylsiloxan (PDMS),
- Perfluoropolyether (PFPE) und/oder
- Tetraethylorthosilicat (TEOS).

Für das Prägen mir flexiblen Stempeln im Vakuum werden bevorzugt Folienrahmen oder auch andere Stempelhalter mit Rahmen verwendet. Der Nanostrukturstempel, insbesondere ein Folienstempel, wird in dem Rahmen gespannt.

Der Rahmen am Folienstempel ermöglicht ein schnelles und einfaches Auswechseln von Stempeln, insbesondere wird durch die mögliche Automatisierung beim Auswechseln des Folienstempels der Prozess vereinfacht. Bevorzugt werden als Rahmen sogenannte Film Frames, die industriell genormt und standardisiert sind.

Der Folienstempel mit Rahmen ist vorzugsweise größer als das Substrat. Der Rahmen wird genutzt, um die lokale Vakuumzone beziehungsweise den evakuierbaren Prägeraum zu definieren. Bei ausreichender Annäherung der oberen und der unteren Aufnahmeeinrichtungen kontaktiert in einer ersten Ausführungsform eine Ringdichtung der Substrat-Aufnahmeeinrichtung mit dem Rahmen, sodass ein evakuierbarer Prägeraum zwischen Folienstempel mit Rahmen und Substrat entsteht. In einer weiteren Ausführungsform befindet sich die Kontaktstelle unmittelbar nach dem Rahmen.

Der Folienstempel ist überwiegend UV-transparent. Der Wellenlangenbereich für die optische Transparenz liegt insbesondere zwischen 100 nm und 1000 nm, vorzugsweise zwischen 150 nm und 500 nm, mit größerem Vorzug zwischen 200 nm und 450 nm, mit größtem Vorzug zwischen 250 nm und 450 nm. Der Folienstempel kann auch für andere Bereiche der elektromagnetischen Strahlung transparent sein. Der Folienstempel kann insbesondere auch im Infrarot-Bereich transparent sein.

In einer eigenständigen Ausführungsform wird die Prägemasse thermisch ausgehärtet. Der Folienstempel muss in dieser Ausführungsform nicht transparent für elektromagnetische Strahlung sein und besteht insbesondere aus einer metallischen Folie. Der insbesondere flexible Folienstempel besteht insbesondere aus mindestens einem der folgenden Materialien:
- Kunststoff
- Metall,
- Metall Legierung.

Die Substrate können jede beliebige Form besitzen, sind aber bevorzugt kreisrund. Der Durchmesser der Substrate ist insbesondere industriell genormt. Für Wafer sind die industrieüblichen Durchmesser, 1 Zoll, 2 Zoll, 3 Zoll, 4 Zoll, 5 Zoll, 6 Zoll, 8 Zoll, 12 Zoll und 18 Zoll. Die Ausführungsform kann aber grundsätzlich jedes Substrat, unabhängig von dessen Durchmesser handhaben.

Bei einer Ausrichtung des Folienstempels und des Substrats werden diese relativ zueinander, insbesondere mit optischen Hilfsmitteln, ausgerichtet. Die Ausrichtung erfolgt insbesondere mit Ausrichtungsmarken, die sich am Folienstempel und am Substrat befinden, wobei Substrat und Folienstempel mindestens zwei Ausrichtungsmarken aufweisen. Dadurch wird eine sehr genaue Positionierung des Folienstempels relativ zum Substrat erreicht. Der Folienstempel und/oder das Substrat sind transparent für die zur Ausrichtung verwendete elektromagnetische Strahlung. Insbesondere ist der Folienstempel transparent für die zur Ausrichtung verwendete elektromagnetische Strahlung.

Substrat sowie Folienstempel-Rahmen und Stempel-Rückplatte werden durch mindestens ein Fixierelement and der korrespondierenden Aufnahmeeinrichtung fixiert. Die Fixierelemente können ein- und ausgeschalten werden. Bei den Fixierelementen handelt es sich vorzugsweise um
- Vakuumfixierungen, insbesondere mit
   Einzeln ansteuerbaren Vakuumbahnen und/oder
   Jeweils mehrere miteinander verbundenen Vakuumbahnen (Vakuumsegmente),
- Mechanische Fixierungen, insbesondere Klemmen,
- Elektrische Fixierungen, insbesondere
   Elektrostatische Fixierungen und/oder
   Magnetische Fixierungen,
- Adhäsive Fixierungen.

Dabei sind die Fixierelemente für Substrat, Folienstempel-Rahmen und Folienstempel-Rückplatte bevorzugt Vakuumfixierungen. Das mindestens eine Fixierelement ist insbesondere elektronisch ansteuerbar.

Die Vakuumfixierung besteht vorzugsweise aus mehreren Vakuumbahnen, die an der Haltefläche der Aufnahmeeinrichtung austreten. Die Vakuumbahnen sind vorzugsweise einzeln ansteuerbar.

In einer bevorzugten Ausführungsform sind einige Vakuumbahnen zu Vakuumbahnsegmenten vereint, die einzeln ansteuerbar, daher evakuiert oder geflutet werden können. Jedes Vakuumsegment ist allerdings unabhängig von den anderen Vakuumsegmenten. Damit erhält man die Möglichkeit des Aufbaus einzeln ansteuerbarer Vakuumsegmente.

Solche einzeln ansteuerbare Vakuumbahnen oder Vakuumsegmente werden in der Haltefläche der Folienstempel-Aufnahmeeinrichtung verwendet, um getrennte Fixierelemente beziehungsweise Fixierzonen jeweils für den
- Folienstempel-Rahmen,
- Äußeren Bereich der Rückplatte ohne Strukturierung und/oder
- Stempel-Bereich der Rückplatte mit Strukturierung zu definieren, für eine verbesserte Kontrolle des Prägevorgangs.

Vakuumsegmente für die Substrat-Fixierung an der Substrat-Aufnahmeeinrichtung sind vorzugsweise ringförmig konstruiert. Dadurch wird eine gezielte, radialsymmetrische, insbesondere von innen nach außen durchgeführter Fixierung und/oder Loslösung des Substrats von der Substrataufnahmeeinrichtung ermöglicht. Alternativ ist auch eine linear durchgeführte Fixierung und/oder Loslösung von Substrat und/oder Folienstempel von der Aufnahmeeinrichtung möglich.

In einer ersten Ausführungsform der Folienstempel- und/oder Substrat-Aufnahmeeinrichtung dienen ein Stift in der zentrischen Bohrung oder eine Leitung, aus dem ein Überdruck durch ein eingeleitetes Gas, zwischen der Haltefläche der Substrat-Aufnahmeeinrichtung und dem Substrat erzeugt werden kann, der steuerbaren Durchbiegung des fixierten Folienstempels und/oder Substrats. Dabei bleibt der Folienstempel oder das Substrat ringförmig im Randbereich fixiert.

In einer zweiten Ausführungsform der Folienstempel und/oder Substrat-Aufnahmeeinrichtung ist ein inneres Vakuumsegment, das als Vakuumfixierung dient, so schaltbar, dass darüber ein Gas und/oder ein Gasgemisch in den Zwischenraum zwischen der Haltefläche der Aufnahmeeinrichtung und der Folienstempel- oder Substratrückseite gepumpt werden kann, zur steuerbaren Durchbiegung des am Rand fixierten Folienstempels und/oder Substrats. Das mindestens eine Fixierelement kann dann gleichzeitig nach Umschaltung als Krümmungsmittel verwendet werden. Durch Design der Vakuumzonen beziehungsweise der Vakuumsegmente erfolgt eine aktive Steuerung der Druckzonen als Krümmungsmittel zum Prägen.

Die Auswahl der eingeleiteten Prozessgase als Gas und/oder Gasgemisch kann einen zusätzlichen Einfluss auf das Bearbeiten von Substraten (Prägen, Imprinten, Bonden) haben. Beispielsweise kann ein deionisierendes Gas gegen statische Aufladung verwendet werden oder leicht angefeuchtetes Helium (He) oder Stickstoff (N2) Gas zur Regulierung der Feuchtigkeit verwendet werden.

Ein wesentlicher Vorteil der Vorrichtung ist, dass die Ausrichtung beziehungsweise Justierung von Substrat und Folienstempel mit einer hohen Genauigkeit unter Normaldruck durchgeführt wird und anschließend durch Ausbildung eines lokalen, räumlich begrenzten und evakuierbaren Prägeraums ein defektfreies und vereinfachtes Prägen im Vakuum möglich ist.

Der Folienstempel-Rahmen kann auch genutzt werden, um die Vakuumzone beziehungsweise den evakuierbaren Prägeraum zu definieren.

Dabei wird ein definierter Bereich beziehungsweise Bearbeitungsraum mittels Dichtungen, insbesondere Ringdichtung(en) zwischen der oberen und der unteren Aufnahmeeinrichtung abgedichtet.

Die Ringdichtung(en) befinden sich in einer bevorzugten Ausführungsform an der Substrat-Aufnahmeeinrichtung.

Der evakuierbarer Prägeraum entsteht durch Annäherung der oberen und der unteren Aufnahmeeinrichtung bis zur Bildung des evakuierbaren Prägeraums durch Abdichtung nach Kontaktierung der Stempel-Aufnahmeeinrichtung und der mit Ringdichtung(en) versehenen Substrat-Aufnahmeeinrichtung. In einer bevorzugten Ausführungsform befinden sich die Dichtungen nach dem Folienstempel-Rahmen, sodass der gesamte Folienstempel-Rahmen sich im Prägeraum befindet.

Im Bereich des Prägeraums befinden sind, bevorzugt in der Substrat-Aufnahmeeinrichtung, Vakuum-Eintrittsöffnungen für die aktive Evakuierung des Prägeraums. Bei den Eintrittsöffnungen handelt es sich gemäß einer Ausführungsform der Erfindung entweder um angebrachte Vakuumlöcher oder vergleichbare Vakuumelemente, mit deren Hilfe der Prägeraum gesteuert evakuiert werden kann.

In einer bevorzugten Ausführungsform wird nur Grob-Vakuum zwischen dem Folienstempel und dem Substrat in dem lokal begrenzten Prägeraum eingestellt.

Ein besonderer Vorteil der Ausführungsformen und Prozesse besteht darin, dass nicht die ganze Vorrichtung beziehungsweise das ganze Präge-Modul evakuiert werden muss. Die Evakuierung des Prägeraums wird somit erst dann durchgeführt, wenn ein Vakuum notwendig ist. Durch den kleineren Raum, der evakuiert werden muss, ist ein vereinfachtes Prägen im Vakuum möglich. Insbesondere wird zuerst die Ausrichtung und Justierung von Substrat und Folienstempel bei Normaldruck durchgeführten. Anschließend wird für ein defektfreies Prägen der Prägevorgang erst nach Evakuierung des Prägeraums durchgeführt.

Nach dem Präge-Vorgang sind Substrat und Folienstempel vorzugsweise vollflächig kontaktiert. Nach dem vollflächigen Kontakt zwischen Folienstempel und Substrat kann der flexible Folienstempel durch einen leichten Überdruck mittels Spülventile abgehoben werden. Die Spülventile befinden sich bevorzugt im äußeren Bereich der Rückplatte beziehungsweise der Folie. Dieser äußere Bereich besitzt keine Strukturierung und ist nicht Teil der Stempelfläche. Währenddessen verbleibt der Folienstempelrahmen an der Stempelaufnahmeeinrichtung fixiert, sodass der Folienstempel auf dem Substrat relaxieren kann. Durch die Kapillarkräfte werden die Strukturen gefüllt und durch die zu diesem Zeitpunkt gegebene Flexibilität kann sich der Folienstempel konform der Substratoberfläche anpassen. Damit kann eine hochauflösende Oberflächenstrukturierung durchgeführt werden.

Die Stempelaufnahmeeinrichtung verfügt insbesondere über mindestens ein Spülventil zur rückseitigen Abhebung des Folienstempels von der Haltefläche der Aufnahmeeinrichtung. Vorzugsweise handelt es sich bei dem mindestens ein Spülventil um ein Fluidelement, über welches ein Gas und/oder Gasgemisch ausströmen kann, um ein Überdruck zwischen der Haltefläche der Stempelaufnahmeeinrichtung und dem Folienstempel zu erzeugen. Die Spülventile befinden sich bevorzugt im äußeren Bereich der Rückplatte beziehungsweise der Folie. Dieser äußere Bereich besitzt keine Strukturierung und ist nicht Teil der Stempelfläche.

In einer ersten Ausführungsform ist die Vakuumfixierung für den Folienstempel-Rahmen sowie für die Bereiche der Rückplatte mit und ohne Strukturierung, von den Fluidelementen für ein Überdruck zum Abheben des Folienstempels (Abhebungselement) getrennt.

In einer zweiten Ausführungsform können einzelne Fixierelemente, insbesondere Vakuumfixierungen für den äußeren Bereich der Rückplatte, der nicht strukturiert ist, umgeschaltet und mit Überdruck versorgt werden. Dadurch können bei Bedarf einzelne Fixierelemente gleichzeitig als Abhebungselement verwendet werden und dadurch die Folie relaxieren.

In einer bevorzugten Ausführungsform des Verfahrens zum Ausrichten und Prägen ist vorgesehen, dass die Spülung beziehungsweise Druckerhöhung im Bereich der Rückseite des Folienstempels (Spülzone) zum relaxieren des Folienstempels an dem Substrat aber auch gleichzeitig für eine gleichmäßige Kraftaufbringung beim Prägen verwendet wird. Beim Prägevorgang wird das Füllen der Strukturen des Folienstempels durch Kapillarkräfte zusätzlich mit dem (leichten) Rückseitigen Überdruck unterstützt.

In einer bevorzugten Ausführungsform des Verfahrens zum Ausrichten und Prägen ist vorgesehen, dass der Druckunterschied zwischen dem Bearbeitungsraum und dem Bereich der Rückseite des Folienstempels (Spülzone) auch zur Entformung des Folienstempels von der Prägemasse verwendet wird.

In einer bevorzugten Ausführungsform des Verfahrens zum Ausrichten und Prägen ist vorgesehen, dass durch die Druckeinstellung und Druckregulierung jeweils im Bearbeitungsraum und in der Spülzone eine aktive Steuerung der Druckzonen zum Prägen und Entformen erfolgt. Der dadurch entstehende Druckunterschied zwischen die zwei Druckzonen wird zur Erzeugung von externen Kräften, die auf den Folienstempel wirken, beim Prägen und Entformen genutzt.

Die Abmessungen der einzelnen Nanostrukturen des Prägemusters der Prägemittel beziehungsweise des Folienstempels liegen vorzugsweise im Mikrometer- und/oder im Nanometerbereich. Die Abmessungen der einzelnen Nanostrukturen der Prägemittel, insbesondere des flexiblen Folienstempels sind kleiner als 1000 µm, mit Vorzug kleiner als 10 µm, mit größerem Vorzug kleiner als 100 nm, mit noch größerem Vorzug kleiner als 10 nm.

Die Genauigkeit, mit der die Erfassungsgeräte, insbesondere Ausrichtungsoptiken, einzeln bewegt werden können, ist besser als 1 mm, mit Vorzug besser als 100 µm, mit großem Vorzug besser als 10 µm, mit größerem Vorzug besser als 1 µm, mit noch größerem Vorzug besser als 100 nm, mit größtem Vorzug besser als 10 nm, mit allergrößtem Vorzug besser als 1 nm.

In einer bevorzugten Ausführungsform wird nach beendeter Ausrichtung nur ein Grob-Vakuum zwischen dem Folienstempel und dem Substrat in dem lokal begrenzten Prägeraum (Bearbeitungsraum) eingestellt.

Bei der Evakuierung ist der Druck in dem Prägeraum kleiner als 500 mbar, mit Vorzug kleiner als 300 mbar, mit größtem Vorzug kleiner als 250 mbar. Insbesondere wird bevorzugt Grobvakuum zwischen 300 mbar und 1 mbar eingestellt, am bevorzugtesten zwischen 250 mbar und 100 mbar.

Der Druck im Bereich der Rückseite des Folienstempels (Spülzone) wird bevorzugt zwischen 1 mbar und 1500 mbar eingestellt. In einer bevorzugten Ausführungsform wird, zusätzlich zum Grob-Vakuum im Bearbeitungsraum, während und/oder nach der (vollflächigen) Kontaktierung zwischen Folienstempel und dem mit Prägemasse beschichteten Substrat der Druck im Bereich der Rückseite des Folienstempels (Spülzone) bevorzugt zwischen 1100 mbar und 1250 mbar eingestellt.

Der Druckunterschied zwischen dem Bearbeitungsraum und dem Bereich der Rückseite des Folienstempels (Spülzone) wird auch zur Entformung des Folienstempels von der Prägemasse verwendet. Beispielsweise wird dafür der Druck im Bearbeitungsraum auf Normaldruck eingestellt während der Druck im Bereich der Rückseite des Folienstempels (Spülzone) zwischen 1100 mbar und 1500 mbar eingestellt wird.

In einer bevorzugten Ausführungsform der Vorrichtung zum Bearbeiten von Substraten ist vorgesehen, dass der Druckunterschied zwischen dem Bearbeitungsraum und der Rückseite des Folienstempels zur aktiven Steuerung der Prägung und der Entformung verwendet wird. Dadurch werden externe Kräfte erzeugt, die zum Bearbeiten des Substrats genutzt werden. Der Bereich der erzeugten Kräfte liegt bevorzugt zwischen 100 N und 10 kN.

Das verwendete UV-Licht ist wahlweise breitbandiges Licht oder speziell abgestimmt auf den verwendeten Photoinitiator im Prägelack. Der Wellenlängenbereich des aushärtbaren Materials liegt insbesondere zwischen 50 nm und 1000 nm, vorzugsweise zwischen 150 nm und 500 nm, mit größerem Vorzug zwischen 200 nm und 450 nm.

Weitere Vorteile, Merkmale und Einzelheiten der Erfindung ergeben sich aus der nachfolgenden Beschreibung bevorzugter Ausführungsbeispiele sowie anhand der Zeichnungen. Diese zeigen schematisch in:
- Figur 1a:: eine Querschnittsansicht der Vorrichtung einer ersten Ausführungsform in einem ersten Verfahrensschritt,
- Figur 1b:: eine Querschnittsansicht der Vorrichtung einer ersten Ausführungsform in einem zweiten Verfahrensschritt,
- Figur 1c:: eine Querschnittsansicht der Vorrichtung einer ersten Ausführungsform in einem dritten Verfahrensschritt,
- Figur 1d:: eine Querschnittsansicht der Vorrichtung einer ersten Ausführungsform in einem vierten Verfahrensschritt,
- Figur 1e:: eine Querschnittsansicht der Vorrichtung einer ersten Ausführungsform in einem fünften Verfahrensschritt,
- Figur 2a:: eine Querschnittsansicht der Vorrichtung einer zweiten Ausführungsform in einem ersten Verfahrensschritt,
- Figur 2b:: eine Querschnittsansicht der Vorrichtung einer zweiten Ausführungsform in einem zweiten Verfahrensschritt,
- Figur 2c:: eine Querschnittsansicht der Vorrichtung einer zweiten Ausführungsform in einem dritten Verfahrensschritt,
- Figur 2d:: eine Querschnittsansicht der Vorrichtung einer zweiten Ausführungsform in einem vierten Verfahrensschritt,
- Figur 2e:: eine Querschnittsansicht der Vorrichtung einer zweiten Ausführungsform in einem fünften Verfahrensschritt,
- Figur 2f:: eine Querschnittsansicht der Vorrichtung einer zweiten Ausführungsform in einem sechsten Verfahrensschritt,
- Figur 2g:: eine Querschnittsansicht der Vorrichtung einer zweiten Ausführungsform mit Substrat-Stempel-Stapel im Belichtungs- und Entformungs-Modul in einem ersten Verfahrensschritt,
- Figur 2h:: eine Querschnittsansicht der Vorrichtung einer zweiten Ausführungsform mit Substrat-Stempel-Stapel im Belichtungs- und Entformungs-Modul in einem zweiten Verfahrensschritt,
- Figur 2i:: eine Querschnittsansicht der Vorrichtung einer zweiten Ausführungsform mit Substrat-Stempel-Stapel im Belichtungs- und Entformungs-Modul in einem dritten Verfahrensschritt,
- Figur 2j:: eine Querschnittsansicht der Vorrichtung einer zweiten Ausführungsform mit Substrat-Stempel-Stapel im Belichtungs- und Entformungs-Modul in einem vierten Verfahrensschritt,
- Figur 3a:: eine Querschnittsansicht der Vorrichtung einer dritten Ausführungsform mit beladenem Substrat und Folienstempel mit Folienrahmen in einem ersten Verfahrensschritt,
- Figur 3b:: eine Querschnittsansicht der Vorrichtung einer dritten Ausführungsform in einem zweiten Verfahrensschritt,
- Figur 3c:: eine Querschnittsansicht der Vorrichtung einer dritten Ausführungsform in einem dritten Verfahrensschritt.

In den Figuren sind gleiche Bauteile oder Bauteile mit der gleichen Funktion mit den gleichen Bezugszeichen gekennzeichnet. Zur Darstellung können Größenverhältnisse falsch wiedergegeben sein.

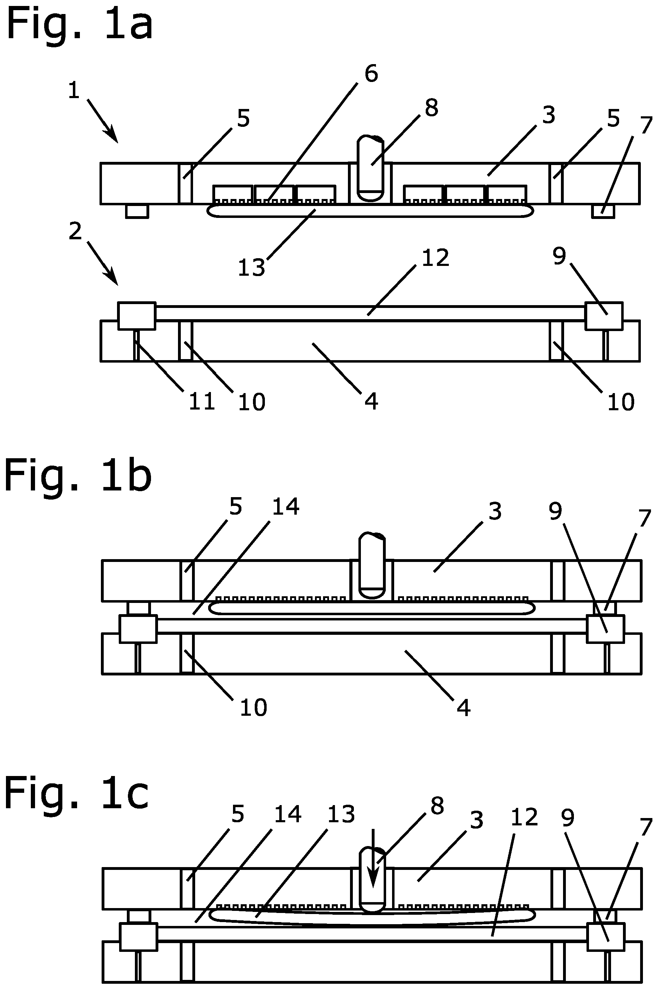

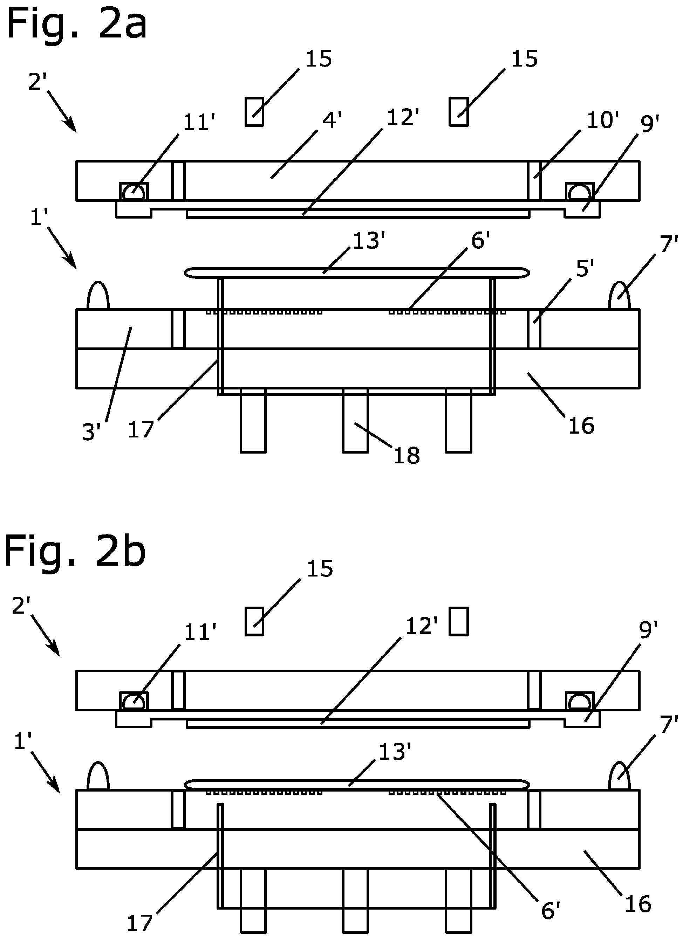

In den Figuren 1a bis 1e ist das Verfahren zum Bearbeiten als Prägeprozess im Ausrichtungs- und Präge-Modul in einer ersten Ausführungsform analog zum Fusionsbonden dargestellt mit dem Folienstempel unten und dem Substrat oben. Die Anordnung ist auch umgekehrt, klassisch mit Folienstempel oben und Substrat unten möglich, wie in einer zweiten Ausführungsform in Figuren 2a bis 2j dargestellt, denkbar. Dabei wird in den Figuren die Einrichtung zum Bearbeiten beispielhaft durch eine Prägeeinrichtung dargestellt. Die Einrichtung zum Bearbeiten kann beispielsweise auch eine Laserbearbeitungseinrichtung, eine Belackungseinrichtung, eine Bond- oder Debondeinrichtung sein. Der lokale Bearbeitungsraum ist dann entsprechend zwischen den Einrichtungen oder den Elementen der Einrichtung und der Substrataufnahmeeinrichtung um das Substrat herum ausbildbar.

Ein wesentlicher Vorteil der Vorrichtung ist, dass zuerst die Justierung und Annäherung von Substrat und der Einrichtung bzw. dem Folienstempel mit einer hohen Justiergenauigkeit unter Normaldruck durchgeführt wird und anschließend in einem räumlich begrenzten, evakuierbaren Prägeraum ein defektfreies und vereinfachtes Prägen im Vakuum möglich ist.

Figur 1a zeigt die Aufnahmeeinrichtungen 1 und 2 einer Vorrichtung zur Aufnahme des Substrats 13 und des Folienstempels 12 mit Folienrahmen 9. Die Substrat-Aufnahmeeinrichtung 1 enthält eine zentrische Öffnung zur Durchführung eines Aktuators 8 beziehungsweise einer Aktuatoreinrichtung (nicht dargestellt). In dieser ersten beispielhaften Ausführungsform wird der Prägeprozess (Nanoimprintprozess) mit dem Aktuator 8 im Substratzentrum initiiert. Der Aktuator 8 kann verschiedene Formen bzw. Ausführungen haben. Anstatt einem Aktuator-Pin oder Stift als Aktuator 8 ist alternativ auch eine Druckbeaufschlagung mit einem Fluid oder einem Gas möglich. Die Öffnung für den Aktuator 8 gemäß Figur 1a kann verschiedene Größen und Formen haben.

In Figur 1a wurde der Folienstempel 12 mit Folienrahmen 9 bereits an der Folienstempel-Aufnahmeeinrichtung 2 aufgenommen. Die Fixierung des Folienrahmens 9 erfolgt über Fixierelemente 11 sowie über in der Haltefläche der Aufnahmeeinrichtung 2 verteilte Vakuumbahnsegmente, die definierte Zonen der Folienrückseite fixieren (nicht dargestellt). Figur 1a zeigt auch die Substrat-Aufnahmeeinrichtung 1 mit geladenem Substrat 13. Das Substrat 13 wird durch Vakuum bzw. Unterdruck über die Vakuumbahnen 6 fixiert. In einer bevorzugten Ausführungsform gemäß Figur 1a sind einige Vakuumbahnen 6 zu Vakuumbahnsegmenten vereint, die einzeln ansteuerbar, daher evakuiert oder geflutet werden können.

Die Substrat-Aufnahmeeinrichtung 1 gemäß Figur 1a enthält Dichtungen, insbesondere Dichtringe 7, um nach Kontaktierung mit der unteren Folienstempel-Aufnahmeeinrichtung 2 einen räumlich begrenzen und abgedichteten Prägeraum 14 zu bilden. Da der Stempel, insbesondere ein Folienstempel 12 mit Rahmen 9, üblicherweise größer ist als das Substrat 13, erfolgt eine Ladung beziehungsweise Belackung des Stempels vorzugsweise außerhalb der Substratzone.

Im nächsten Prozessschritt gemäß Figur 1b wird nach der Ausrichtung beziehungsweise Justierung und Annäherung bis zur Kontaktierung der oberen und der unteren Aufnahmeeinrichtungen 1, 2 an den Dichtungen 7 der Prägeraum 14 gebildet. Der Prägeraum 14 wird über Vakuum-Leitungen 5 in der Substrat-Aufnahmeeinrichtung 1 evakuiert. Der Rahmen 9 wird gemäß Figur 1b genutzt, um die lokale Vakuumzone beziehungsweise den evakuierbaren Prägeraum 14 zu definieren. Alternativ ist auch eine Abdichtung nach dem Rahmen 9 möglich.

Im nächsten Prozessschritt gemäß Figur 1c werden, nach abgeschlossener Evakuierung des Prägeraums 14 und somit nach Anbringen des Vakuums zwischen Substrat 13 und Folientempel 12, der Folienstempel 12 und das Substrat 13 möglichst punktförmig an einer Teilfläche kontaktiert. Die in Figur 1c gezeigte Kontaktierung erfolgt durch eine konzentrische Verformung des Substrats 13 durch den über den Aktuator 8 ausgeübten Druck, insbesondere in der Mitte des Substrats 13. Dabei bleibt das Substrat 13 ringförmig im Randbereich fixiert. Das Substrat 13 wird kontrolliert verbogen bis zur Kontaktierung des Folienstempels 12 und dann losgelassen und kontaktiert nach vollständiger Loslösung den Folienstempel 12 vollflächig. Das Vakuum verhindert dabei mögliche Lufteinschlüsse.

Anstatt einen Stift als Aktuator 8 in der zentrischen Bohrung der Substrat-Aufnahmeeinrichtung ist auch eine Leitung, aus dem ein Überdruck durch ein eingeleitetes Gas, zwischen der Haltefläche der Substrat-Aufnahmeeinrichtung und dem Substrat 13 erzeugt werden kann, für die steuerbare Durchbiegung des fixierten Substrats 13 möglich.

Die Vakuumfixierung für das Substrat 13 besteht vorzugsweise aus mehreren Vakuumbahnen 6, die an der Haltefläche der Substrat-Aufnahmeeinrichtung austreten. In einer bevorzugten Ausführungsform sind einige Vakuumbahnen 6 zu Vakuumbahnsegmenten vereint, die einzeln ansteuerbar sind. Die Vakuumsegmente für die Substrat-Fixierung an der Substrat-Aufnahmeeinrichtung sind vorzugsweise ringförmig konstruiert. Dadurch wird eine kontrollierte, radialsymmetrische, insbesondere von innen nach außen durchgeführte, Loslösung des Substrats 13 von der Substrat-Aufnahmeeinrichtung nach der Kontaktierung ermöglicht.

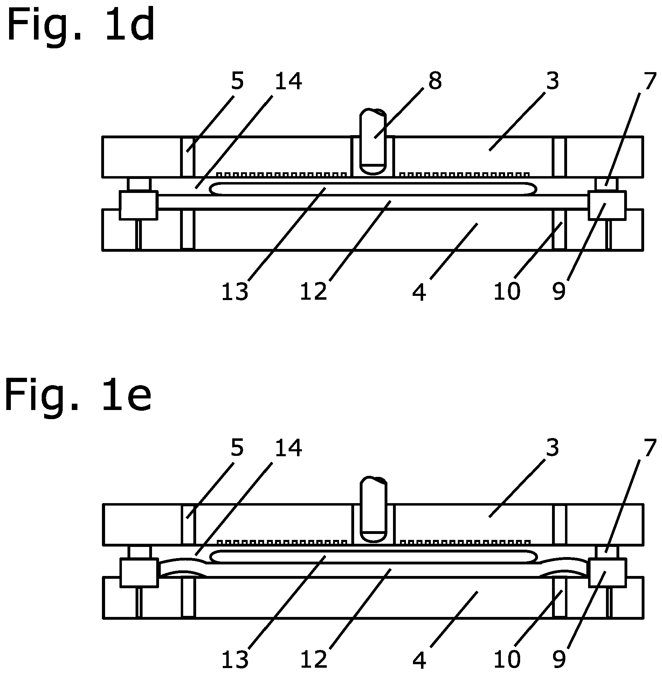

Figur 1d zeigt eine abgeschlossene Prägewelle, bei der die Prägefront den Rand des Substrats 13 erreicht hat. Das Substrat 13 und der Folienstempel 12 sind annähernd vollflächig kontaktiert und das Substrat 13 ist nicht mehr an der oberen Substrat-Aufnahmeeinrichtung fixiert. Der Aktuator 8 kann nach Bedarf zunächst in Kontakt mit dem Substrat verbleiben und/oder in die zentrische Öffnung zurückgefahren werden.

Die Folienstempel-Aufnahmeeinrichtung 2 gemäß Figuren 1a bis 1e verfügt über zusätzliche Ventile bzw. Gas-Leitungen, insbesondere über mindestens ein Spülventil 10 zur rückseitigen Abhebung des Folienstempels 12 von der Haltefläche der Folienstempel-Aufnahmeeinrichtung 2. Vorzugsweise handelt es sich bei dem mindestens ein Spülventil 10 um ein Fluidelement, über welches ein Gas und/oder ein Gasgemisch ausströmen kann, um ein Überdruck zwischen der Haltefläche der Stempelaufnahmeeinrichtung und dem Folienstempel 12 zu erzeugen. Die Spülventile befinden sich bevorzugt im äußeren Bereich der Rückplatte beziehungsweise der Folie des Folienstempels 12. Dieser äußere Bereich besitzt keine Strukturierung und ist nicht Teil der Stempelfläche.

Gemäß Figur 1e wird nach dem vollflächigen Kontakt zwischen Folienstempel 12 und Substrat 13 der flexible Folienstempel 12 durch einen Überdruck zwischen der äußeren Haltefläche der Folienstempel-Aufnahmeeinrichtung und dem Folienstempel 12 "losgelassen". Währenddessen verbleibt der Folienstempelrahmen 9 an der Folienstempel-Aufnahmeeinrichtung fixiert, sodass der Folienstempel 12 auf dem Substrat relaxieren kann. Durch die Kapillarkräfte werden die Strukturen gefüllt und durch die zu diesem Zeitpunkt gegebene Flexibilität kann sich der Folienstempel 12 konform der Substratoberfläche anpassen. Das Delta der Umgebungsdrücke kann als zusätzliche externe Kraft genutzt werden, um das Füllverhalten zu verbessern.

Um die Ausrichtungsgenauigkeit möglichst hoch zu halten ist vorgesehen, dass der Imprint extern in einem zweiten Modul der Vorrichtung ausgehärtet und entformt wird. Alternativ wäre das auch mit diesem Aufbau denkbar, würde aber den Aufbau deutlich komplexer machen und einen ungewünschten Temperatureintrag hervorrufen.

Die Figuren 2a bis 2j zeigen die Prozessschritte in einer zweiten Ausführungsform der Vorrichtung und des Verfahrens.

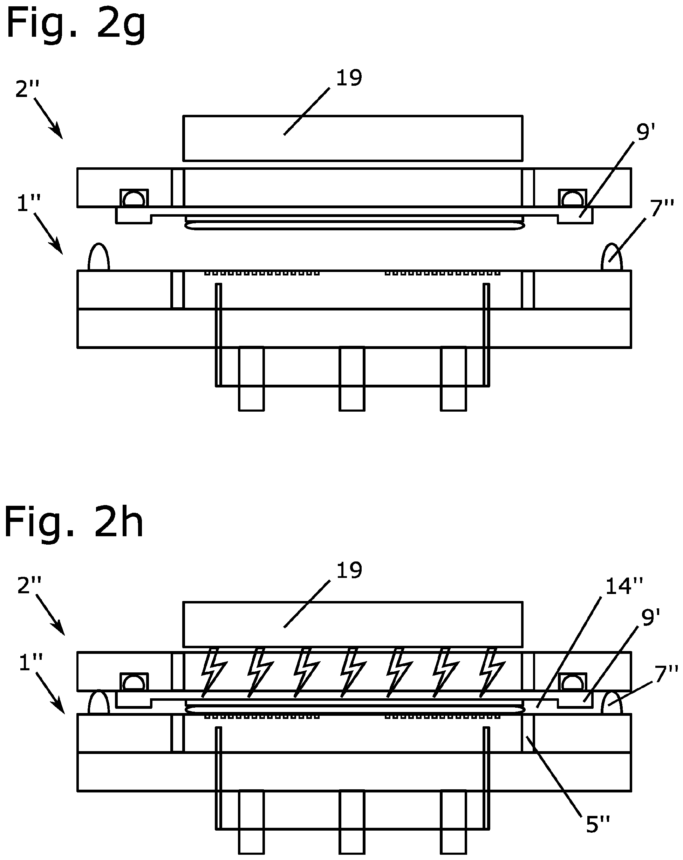

Die Vorrichtung verfügt insbesondere über eine Modulgruppe mit einem gemeinsamen, und bei Bedarf gegenüber der Umgebungsatmosphäre abschließbaren, Arbeitsraum. Die Vorrichtung besteht insbesondere aus mindestens zwei Modulen. Ausrichtung und Prägung werden in einem ersten Modul gemäß Figuren 2a bis 2f durchgeführt. Aushärtung und Entformung werden insbesondere in einem zweiten Modul gemäß Figuren 2g bis 2j durchgeführt. Die Belackung kann vom Prägeprozess getrennt in einem eigenen Modul durchgeführt werden.

In einen ersten Verfahrensschritt werden Substrat 13' und Folienstempel 12' beladen und an den jeweiligen Aufnahmeeinrichtungen 1', 2' aufgenommen und fixiert.

Figur 2a zeigt die Aufnahmeeinrichtungen 1' und 2' einer Vorrichtung zur Aufnahme des Substrats 13' und des Folienstempels 12' mit Folien-Rückplatte und -Rahmen 9'. In dieser zweiten Ausführungsform befindet sich der Folienstempel 12' oben and der Folienstempel-Aufnahmeeinrichtung 2' und das Substrat 13' unten an der Substrat-Aufnahmeeinrichtung 1'.

In Figur 2a wurde der Folienstempel 12' mit Rückplatte samt Folienrahmen 9' bereits an der Folienstempel-Aufnahmeeinrichtung 2' aufgenommen. Die Fixierung des Folienrahmens 9' erfolgt über Fixierelemente 11' sowie über in der Haltefläche der Aufnahmeeinrichtung 2' verteilte Vakuumbahnsegmente, die definierte Zonen der Folienrückseite fixieren (nicht dargestellt). Insbesondere werden strukturierte Stempelbereiche und nicht-strukturierte Bereiche der (Folien)-Rückplatte in unterschiedliche Vakuumbahnsegmente unterteilt.

In Figur 2a wurde das Substrat 13' auf Ladestifte 17 der Substrat-Aufnahmeeinrichtung 1' abgelegt.

Figur 2b zeigt das Substrat 13' nach der Aufnahme an der Aufnahmefläche des Aufnahmekörpers 3' einer Substrat-Aufnahmeeinrichtung 1', wobei die Beladung von oben erfolgt. Das Substrat 13' wird durch Vakuum bzw. Unterdruck über die Vakuumbahnen 6' fixiert. In einer bevorzugten Ausführungsform sind einige Vakuumbahnen 6' zu Vakuumbahnsegmenten vereint, die einzeln ansteuerbar, daher evakuiert oder geflutet werden können (nicht dargestellt).

Befindet sich das Substrat 13' an der unteren Aufnahmeeinrichtung, sowie in der Ausführungsform gemäß Figuren 2a bis 2j dargestellt, ist alternativ oder zusätzlich zur Vakuumfixierung in einer weiteren Ausführungsform eine mechanische Fixierung für das Substrat 13' möglich.

Die Beschichtung bzw. Belackung des Substrats 13' mit der Prägemasse (Prägelack) kann wahlweise vom Prägeprozess getrennt in einem eigenen Modul durchgeführt werden oder im Ausrichtungs- und Prägemodul nach Fixierung des Substrats 13' durchgeführt werden. Die Erfindung kann in Kombination mit den etablierten industriellen Belackungsverfahren angewendet werden wie beispielsweise Spin-Coating Verfahren. Somit ist das Belacken vom Substrat schnell, defektfrei, vollflächig, frei von Partikel und standardisiert, was auch Durchsatz-Vorteile bringt beim Präge-Schritt. In einer ersten Ausführungsform wird das Substrat 13' vor dem Beladen mit einer Prägemasse beschichtet. In einer weiteren Ausführungsform wird das Substrat 13' erst nach der Beladung und Fixierung mit einer Aufbringeinrichtung beschichtet (nicht dargestellt).

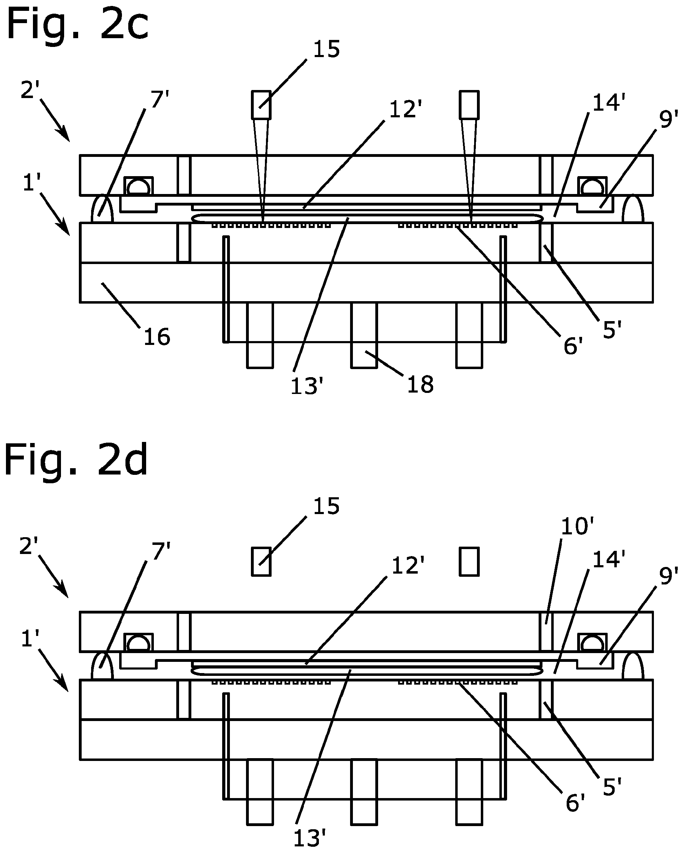

In einem zweiten Verfahrensschritt gemäß Figur 2c wird der Folienstempel 12' relativ zum Substrat 13', insbesondere mit optischen Hilfsmitteln 15, ausgerichtet. Folienstempel 12' und Substrat 13' werden relativ zueinander angenähert.

In einer bevorzugten Ausführungsform ist es vorgesehen, dass das Substrat 13' und/oder die Substrat-Aufnahmeeinrichtung 1' in mindestens drei Freiheitsgraden beweglich ist, bevorzugt in mindestens vier Freiheitsgraden, bevorzugter in mindestens fünf Freiheitsgraden, am bevorzugtesten in allen sechs Freiheitsgraden.

Im Ausrichtungs- und Präge-Modul gemäß Figuren 2a bis 2f befindet sich, insbesondere an der Ober- und Unterseite, jeweils eine Justiereinheit 16 für Substrat 13' und Folienstempel 12'. Auf jeder Justiereinheit befindet sich die korrespondierende Aufnahmeeinrichtung 1', 2'. Jede Aufnahmeeinrichtung 1', 2' besitzt insbesondere sechs Freiheitsgrade, drei Freiheitsgrade der Translation entlang der X-, Y- und Z-Richtung sowie drei Freiheitsgrade der Rotation um die X-, Y- und Z-Achse. Die Translationsfreiheitsgrade dienen der Verschiebung der Aufnahmeeinrichtung 1', 2' und damit des Substrats 13' oder des Folienstempels 12' innerhalb der der durch die X und Y-Richtung aufgespannten X-Y Ebene sowie der Annäherung von Substrat 13' und Folienstempel 12' zueinander entlang der Z-Richtung. Die Rotationsmöglichkeit um die X-, Y- und Z-Achse dient zur Durchführung eines Keilfehlerausgleichs (engl.: wedge error compensation, WEC Z-Achse 18) und/oder der Orientierung von Substrat und/oder Folienstempel. Bei den Rotationen um die X-, Y- und Z-Achse handelt es sich insbesondere um Rotationen mit geringen Rotationswinkeln, sodass man auch von einer Kippung sprechen könnte.

Die Z-Richtung beziehungsweise Z-Achse verläuft in der Beladungs-Position senkrecht als Flächennormale zur Haltefläche der Aufnahmeeinrichtungen 1, 1', 1", 2, 2', 2". Die X- und Y- Richtungen beziehungsweise X- und Y-Achsen verlaufen senkrecht zueinander und parallel zur bzw. in der Haltefläche der Aufnahmeeinrichtungen.

In einer anderen Ausführungsform ist es vorgesehen, dass das Positionier-, Halte- und Bewegungssystem der oberen und unteren Aufnahmeeinrichtungen 1, 1', 1", 2, 2', 2'' für mindestens einen Freiheitsgrad mit einem Grobantrieb und einem Feinantrieb ausgebildet ist.

In einer bevorzugten Ausführungsform ist es vorgesehen, dass die Aufnahmeeinrichtungen 1, 1', 1'', 2, 2', 2'' eine zentrale Steuereinheit und/oder Regeleinheit zur Steuerung und/oder Regelung von Bewegungen und/oder Abläufen aufweist, insbesondere der Fixierung von Substrat 13, 13' und Folienstempel 12, 12' und der Position der Aufnahmeeinrichtungen 1, 1', 1", 2, 2', 2". Zudem weisen die Aufnahmeeinrichtungen 1, 1', 1", 2, 2', 2" mindestens einen Sensor (nicht dargestellt) zur Messung von Einflussfaktoren, insbesondere mindestens ein Abstands- und/oder Positionssensor.

In einem dritten Verfahrensschritt gemäß Figur 2c erfolgt nach ausreichender Annäherung der Aufnahmeeinrichtungen 1', 2' die Bildung eines lokal begrenzten und evakuierbaren Prägeraums 14'. Dabei wird ein definierter Bereich 14' mittels Dichtungen 7', insbesondere Ringdichtung(en) zwischen der oberen und der unteren Aufnahmeeinrichtungen 1', 2' abgedichtet. Dieser Bereich kann bei Bedarf evakuiert werden. Die Ringdichtung(en) 7' befinden sich in einer bevorzugten Ausführungsform an der Substrat-Aufnahmeeinrichtung 1'. Dieser evakuierbarer Prägeraum 14' entsteht durch Annäherung der oberen und der unteren Aufnahmeeinrichtung bis zur Bildung des Prägeraums durch Abdichtung nach Kontaktierung der Stempel-Aufnahmeeinrichtung 2' und der mit Ringdichtung(en) 7' versehenen Substrat-Aufnahmeeinrichtung 1'. In einer bevorzugten Ausführungsform befinden sich die Dichtungen nach dem Folienstempel-Rahmen 9', sodass sich der gesamte Folienstempel-Rahmen 9' im Prägeraum befindet. In alternativen Ausführungsformen können die Dichtungen 7' an jeweils beiden Aufnahmeeinrichtungen oder nur an einer der Aufnahmeeinrichtungen 1', 2' angebracht sein.

Im Bereich des Prägeraums 14' befinden sind, bevorzugt in der Substrat-Aufnahmeeinrichtung 1', Vakuum-Eintrittsöffnungen 5' für die aktive Evakuierung des Prägeraums 14'. Bei den Eintrittsöffnungen 5' handelt es sich gemäß einer bevorzugten Ausführungsform der Erfindung entweder um angebrachte Vakuumlöcher oder vergleichbare Vakuumelemente, mit deren Hilfe der Prägeraum 14' gesteuert evakuiert werden kann.

Figur 2c zeigt den ausgebildeten Prägeraum 14' durch Kontaktierung der oberen und der unteren Aufnahmeeinrichtung 1', 2' am Dichtring 7' nach ausgerichteter Zusammenführung. Der Abstand zwischen Substrat 13' und Folienstempel 12' wurde auf einen genau definierten Abstand reduziert, bevor der Prägeprozess gestartet wird.

Der Folienstempel 12' wird noch relativ zum Substrat 13', mit optischen Hilfsmitteln 15, ausgerichtet, bevor mit der Evakuierung des Prägeraums 14' begonnen wird. Eine weitere Feinausrichtung des Folienstempels 12' kann auch nach der Evakuierung des Prägeraums 14' relativ zum Substrat 13' erfolgen. Dabei findet vorab die Ausrichtung, insbesondere mit optischen Hilfsmitteln 15, vor der Evakuierung des Bearbeitungsraums statt, damit vorteilhaft eine besonders genaue Ausrichtung bei Normaldruck stattfinden kann. Weiterhin kann auch das Substrat 13' nach der Evakuierung des Bearbeitungsraums beispielsweise gedreht werden, um einen Keilfehler auszugleichen. Dies wird insbesondere mittels einer WEC 18 durchgeführt.

In einem vierten Verfahrensschritt gemäß Figur 2d erfolgt eine Prägung der Prägemasse durch den Folienstempel 12'. Dabei wird ein Aktuator verwendet, um das Substrat 13', insbesondere zentrisch, konvex zu krümmen und dadurch mit seinem zentrischen Teil zuerst den Folienstempel 12' zu kontaktieren (nicht dargestellt). Das Substrat 13' bleibt während der Verformung insbesondere am Umfangsrand mit der Substrat-Aufnahmeeinrichtung 1' fixiert.

In dieser zweiten Ausführungsform der Substrat-Aufnahmeeinrichtung 1' ist ein inneres Vakuumsegment, das als Vakuumfixierung dient, so schaltbar, dass darüber ein Gas und/oder ein Gasgemisch in den Zwischenraum zwischen der Haltefläche der Substrat-Aufnahmeeinrichtung 1' und der Substratrückseite gepumpt werden kann, zur steuerbaren Durchbiegung des am Rand fixierten Substrats. Das mindestens eine zentrale Fixierelement kann somit gleichzeitig nach Umschaltung als Krümmungsmittel verwendet werden.

Nach dem Loslösen des verformten i.e. durchgebogenen Substrats 13' erfolgt durch das Voranschreiten einer Prägewelle ein kontinuierliches und gleichmäßiges Prägen entlang der Prägefront.

Gemäß Figur 2d werden Substrat 13' und Folienstempel 12' mit der dazwischenliegenden Prägemasse durch Kapillarkräfte zusammengehalten und vollflächig kontaktiert. Dafür muss mindestens der Folienstempel 12' eine hohe Flexibilität aufweisen. Auf Grund der Viskosität der Prägemasse werden auch durch Kapillarwirkung die Zwischenräume des Folienstempels 12' insbesondere vollständig damit ausgefüllt.

Ein weiteres eigenständiges Merkmal der vorgeschlagenen Erfindung ist, dass nach dem vollflächigen Kontakt zwischen Folienstempel 12' und Substrat 13' der flexible Folienstempel 12' durch einen leichten rückseitigen Überdruck mittels Spülventile 10' relaxiert wird, während der Folienrahmen 9' fixiert verbleibt. Somit kann der Folienstempel 12' auf dem Substrat 13' relaxieren. Durch die Kapillarkräfte werden die Strukturen gefüllt und durch die zu diesem Zeitpunkt gegebene Flexibilität kann sich der Folienstempel 12' konform der Substratoberfläche anpassen. Damit kann eine hochauflösende Oberflächenstrukturierung durchgeführt werden.

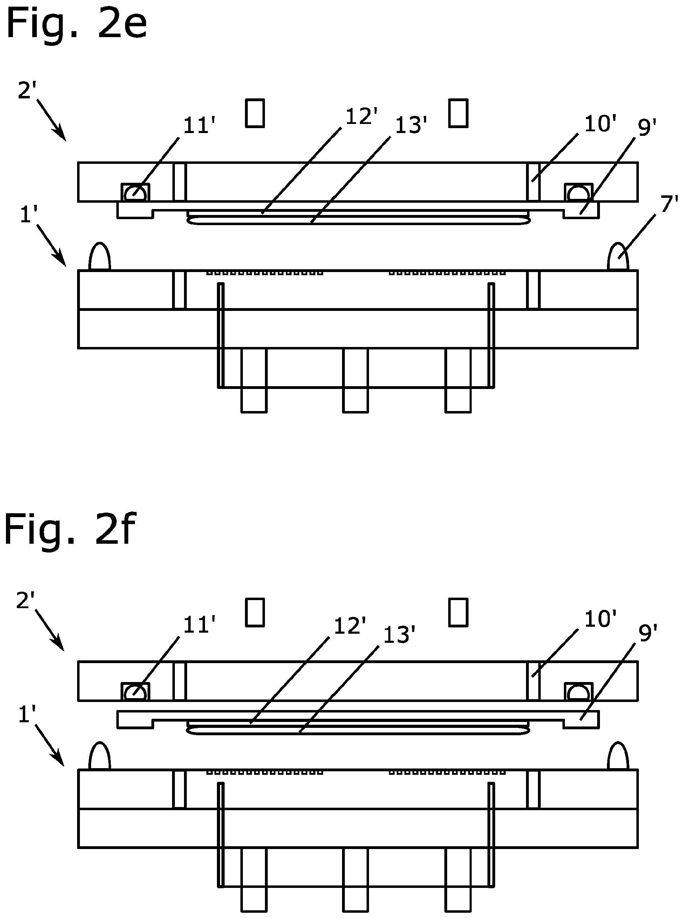

In einem fünften Verfahrensschritt erfolgt die Aushärtung der Prägemasse. Um die Ausrichtungsgenauigkeit möglichst hoch zu halten ist vorgesehen, dass der Imprint extern ausgehärtet und entformt wird. Gemäß Figuren 2e und 2f wird nach Öffnung des Prägeraums der Rahmen 9' mit Folienstempel- und Substrat-Stapel von der oberen Folienstempel-Aufnahmeeinrichtung 2' entfernt und in das Aushärte- und Entformungs-Modul transferiert.

Gemäß Figuren 2g und 2h wird nach dem Prägevorgang im Ausrichtungs- und Präge-Modul der Folienstempel-Substrat-Stapel auf eine Unload-Station transferiert (nicht dargestellt) und anschließend im Aushärte- und Ablöse-Modul die Prägemasse beziehungsweise der Lack durch den transparenten Folienstempel mittels UV-Licht vernetzt.

Das Aushärte- und Ablöse-Modul gemäß Figur 2g besitzt analog dem Ausrichtungs- und Präge-Modul gemäß Figuren 2a bis 2f eine Substrat-Aufnahmeeinrichtung 1" und eine Folienstempel-Aufnahmeeinrichtung 2", auf dessen genaue Beschreibung hier verzichtet wird.

Nach Fixierung des Folienstempel-Substrat-Stapels an der Folienstempel-Aufnahmeeinrichtung 2" gemäß Figur 2g werden die Aufnahmeeinrichtungen 1", 2" angenähert bis auf einen definierten Abstand gemäß Figur 2h zur Bildung des durch die Ringdichtung(en) 7" definierten Raums 14". Der Raum 14" wird nach Bedarf evakuiert. Das UV-Lampenhaus 19 ermöglicht die Bestrahlung des Prägelacks mittels UV-Licht. Dabei erfolgt bei der Aushärtung mit UV-Strahlung eine Temperaturkontrolle und bei Bedarf ein Temperaturausgleich.

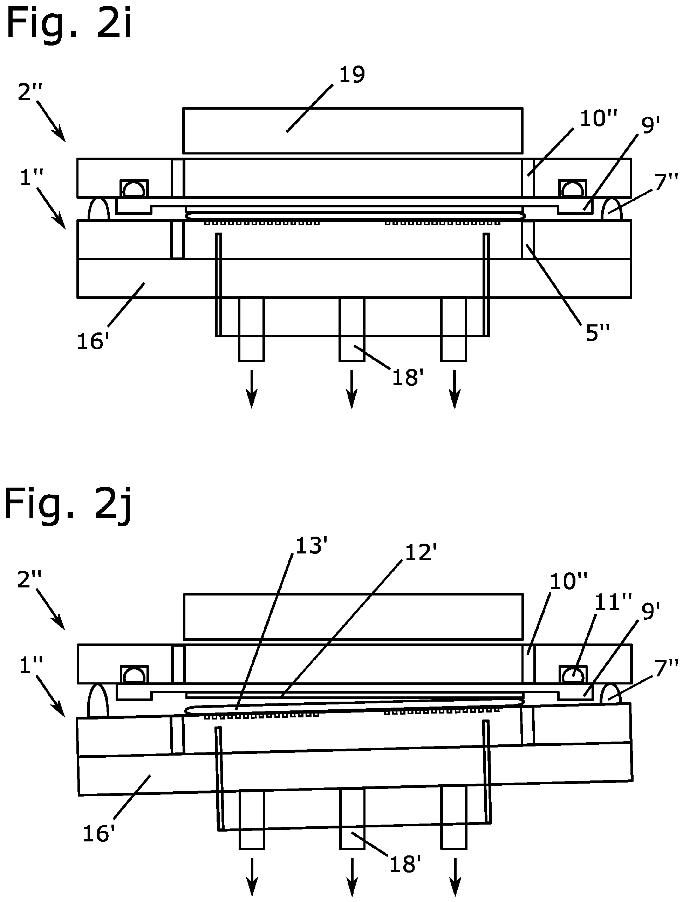

In einem sechsten Verfahrensschritt erfolgt die Entformung des Folienstempels 12' von der Prägemasse gemäß Figuren 2i und 2j. Am Ende des Verfahrens wird im Aushärte- und Ablöse-Modul der Folienstempel 12' insbesondere vom Substrat 13' abgezogen und das Substrat 13' entladen. Die Anlage verfügt vorzugsweise über Sensoren zur Kraftüberwachung für eine Kontrolle des Entformungsschrittes.

Im Aushärte- und Ablöse-Modul gemäß Figuren 2g bis 2j befindet sich, insbesondere an der Unterseite, eine Justiereinheit 16' für die Aufnahmeeinrichtung 1". Die Aufnahmeeinrichtung 1" besitzt insbesondere sechs Freiheitsgrade, drei Freiheitsgrade der Translation entlang der X-, Y- und Z-Richtung sowie drei Freiheitsgrade der Rotation um die X-, Y- und Z-Achse. Die Translationsfreiheitsgrade dienen der Verschiebung der Aufnahmeeinrichtung 1" und damit des Substrats 13' innerhalb der der durch die X und Y-Richtung aufgespannten X-Y Ebene sowie der Bewegung von Substrat 13' und Folienstempel 12' zueinander entlang der Z-Richtung. Die Rotationsmöglichkeit um die X-, Y- und Z-Achse dient zur Durchführung eines Keilfehlerausgleichs (engl.: wedge error compensation, WEC Z-Achse 18') und/oder der Orientierung von Substrat 13' zur Entformung.

Figuren 2h und 2i zeigen Leitungen 5" die wahlweise als Vakuum-Leitungen zur Evakuierung des Raumes 14" oder als Spülventile zur Spülung oder Ausbildung eines Überdrucks in dem Raum 14" mittels Gas oder Gasmischungen verwendet werden können. Die Entformung wird durch Spülung des Raumes 14" zwischen bzw. rundum Folienstempel 12' und Substrat 13' unterstützt. Dadurch kann eine gezielte, zusätzliche Beeinflussung der Entformung erreicht werden. Zusätzlich kann auch der flexible Folienstempel 12' während der Entformung durch einen leichten rückseitigen Überdruck mittels Spülventile 10" relaxiert werden, während der Folienrahmen 9' fixiert verbleibt.

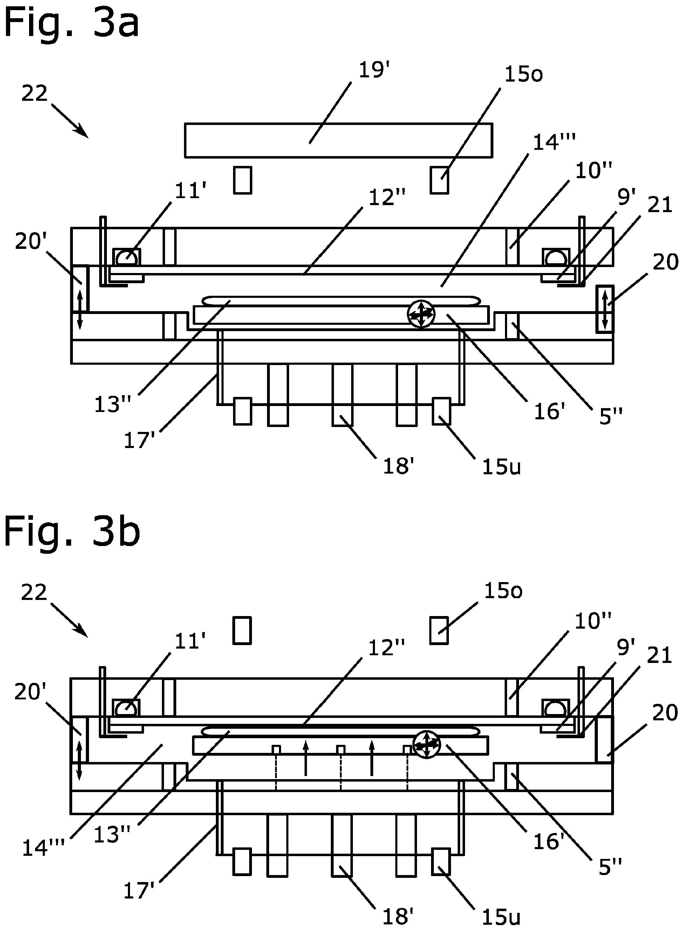

In Figuren 3a bis 3c sind die Vorrichtung und das Verfahren zum Bearbeiten als Prägeprozess in einer dritten Ausführungsform dargestellt mit dem Folienstempel am Film-Frame 9' oben und dem Substrat 13" unten. In der Vorrichtung gemäß Figuren 3a bis 3c werden im gleichen Modul bevorzugt Ausrichtung, Prägung, Aushärtung und Entformung durchgeführt. Die Vorrichtung gemäß Figuren 3a bis 3c besitzt eine fixe Bauform, bei der die unteren und oberen Teile der Vorrichtung, in denen die Aufnahmeeinrichtungen integriert sind, nicht trennbar sind. Die Substrataufnahmeeinrichtung mit Justiereinheit 16' mit der Aufnahmefläche zur Aufnahme des Substrats 13" ist im unteren Teil der Vorrichtung integriert und möglichst platzsparend dimensioniert. Somit kann vorteilhaft ein möglichst reduzierter Bearbeitungsraum 14‴ ausgebildet werden. Der räumlich abgegrenzter und evakuierbarer Bearbeitungsraum 14‴ um das Substrat wird durch die Gatevalves 20, 20' definiert. Die Gatevalves 20, 20' sind Be- und und Entladeöffnungen für ein gasdichtes Abschließen des Bearbeitungsraumes und sind jeweils in einer Wand der Prozesskammer ausgebildet. Die Evakuierung erfolgt durch Mittel zur Evakuierung 5", welche an der Einrichtung angeordnet sind, so dass nach Schließung der Gatevalve 20, 20' der Bearbeitungsraum 14‴ evakuiert werden kann. Dabei sind das Substrat 13" und der Folienstempel 12" mit Film Frame 9' innerhalb des Bearbeitungsraumes 14‴ angeordnet. Die Bearbeitung findet dabei in dem Bearbeitungsraum statt.

In einer beispielhaften Ausführungsform des Verfahrens mit der Vorrichtung gemäß Figuren 3a bis 3c sind die Schritte c) Annäherung der oberen und/oder der unteren Aufnahmeeinrichtung und d) Evakuierung/Ausbilden des Vakuums im definierten Prägeraum zwischen Folienstempel und Substrat, beliebig austauschbar.

Bevorzugt nähert sich die untere Substrataufnahmeeinrichtung mit Justiereinheit 16' dem oberen Stempel.

In Figur 3a wurde der Folienstempel mit Rückplatte samt Film-Frame 9' bereits an der Folienstempel-Aufnahmeeinrichtung aufgenommen. Die Aufnahme erfolgt durch die Film Frame Ladeeinheit 21 nach Einführung in die Vorrichtung über eine Gatevalve 20, 20'. Die Fixierung des Folienrahmens 9' erfolgt über Fixierelemente 11' sowie über in der Haltefläche der Aufnahmeeinrichtung verteilte Vakuumbahnsegmente, die definierte Zonen der Folienrückseite fixieren (nicht dargestellt). Insbesondere werden strukturierte Stempelbereiche und nicht-strukturierte Bereiche der (Folien)-Rückplatte in unterschiedliche Vakuumbahnsegmente unterteilt.

Der Folienstempel ist in einem Rahmen, insbesondere in einem Film Frame 9' gespannt.

Das Substrat kann zwischengelagert werden (nicht dargestellt) und mittels einer Handhabungseinrichtung (nicht dargestellt), beispielsweise eines Roboterarms, durch eines der Gatevalve 20, 20' in die Prozesskammer auf die Substrat-Ladestifte 17' transferiert werden. Danach wird das Gatevalve 20, 20' wieder geschlossen. Das Vorhandensein von zwei Gatevalves 20, 20' ermöglicht mehr Flexibilität in der Prozessdurchführung. Ein Gatevalve kann beispielsweise für die Einführung und Abnahme des Substrats 13" genutzt werden, während das zweite Gatevalve für die Einführung und Abnahme des Folienstempels 12" mit Film Frame 9' verwendet wird. Mehrere Substrate und/oder unterschiedliche Substrate können mit einem einzigen Folienstempel geprägt werden. Der Folienstempel kann in der Vorrichtung gemäß Figur 3a für mehrere Prägevorgänge verbleiben.

Figur 3a zeigt das mit Prägelack beschichtete Substrat 13" nach der Aufnahme an der Aufnahmefläche des Aufnahmekörpers einer Substrat-Aufnahmeeinrichtung, wobei die Beladung über die Ladestifte 17' von oben erfolgt nach Einführung in die Vorrichtung über ein Gatevalve 20, 20'. Das Substrat 13" wird durch Vakuum bzw. Unterdruck über die Vakuumbahnen fixiert. In einer bevorzugten Ausführungsform sind einige Vakuumbahnen zu Vakuumbahnsegmenten vereint, die einzeln ansteuerbar, daher evakuiert oder geflutet werden können (nicht dargestellt). Befindet sich das Substrat 13" an der unteren Aufnahmeeinrichtung, sowie in der Ausführungsform gemäß Figur 3a dargestellt, ist alternativ oder zusätzlich zur Vakuumfixierung in einer weiteren Ausführungsform eine mechanische Fixierung für das Substrat 13" möglich.

Eine Erfassungseinrichtung, insbesondere mit Optiken 15o, 15u sorgt gemäß einer vorteilhaften Ausführungsform für die exakte Ausrichtung von Substrat 13" und Folienstempel 12", indem sie die relativen Positionen erfasst, an die Steuerungseinheit weitergibt, welche dann eine Ausrichtung von Substrat und Folienstempel zueinander bewirkt.

Der Folienstempel 12" wird in einer ersten Ausführungsform noch relativ zum Substrat 13'', mit optischen Hilfsmitteln 15o, 15u ausgerichtet, bevor mit der Evakuierung des Prägeraums 14‴ begonnen wird. Eine weitere Feinausrichtung des Folienstempels 12" kann auch nach der Evakuierung des Prägeraums 14‴ relativ zum Substrat 13" erfolgen. Weiterhin kann auch das Substrat 13" nach der Evakuierung des Bearbeitungsraums 14‴ beispielsweise gedreht werden, um einen Keilfehler auszugleichen. Dies wird insbesondere mittels einer WEC 18' (engl.: wedge error compensation) durchgeführt.

Der Abstand zwischen Substrat 13" und Folienstempel 12" wird im nächsten Verfahrensschritt gemäß Figur 3b auf einen genau definierten Abstand reduziert, bevor der Prägeprozess gestartet wird. Bevorzugt nähert sich die untere Substrat-Aufnahmeeinrichtung relativ zum Folienstempel 12".

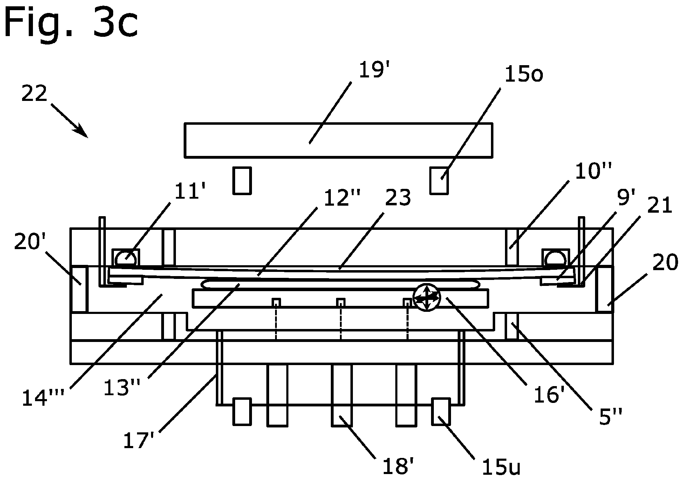

Im nächsten Verfahrensschritt gemäß Figur 3c erfolgt eine Prägung der Prägemasse durch den Folienstempel 12". In einer bevorzugten Ausführungsform der Aufnahmeeinrichtung für den Folienstempel mit Film Frame ist ein inneres Vakuumsegment, das als Vakuumfixierung dient, so schaltbar, dass darüber ein Gas und/oder ein Gasgemisch in den Zwischenraum zwischen der Haltefläche der Aufnahmeeinrichtung für den Folienstempel mit Film Frame und der Folienstempelrückseite gepumpt werden kann, zur steuerbaren Durchbiegung des am Rand fixierten Folienstempels. Das mindestens eine zentrale Fixierelement kann somit gleichzeitig nach Umschaltung als Krümmungsmittel verwendet werden.

Die Kontaktierung in der Vorrichtung gemäß Figur 3b erfolgt bevorzugt nach Annäherung der unteren Substrat-Aufnahmeeinrichtung wobei durch Vorspannung des oberen Folienstempels zunächst nur eine Teilfläche des Folienstempels 12" mit dem Substrat 13" kontaktiert wird und anschließend ein selbsttätiges Kontaktieren der Kontaktflächen bewirkt wird, wobei bevorzugt die gesamte Substratfläche ohne Wiederholen der vorgenannten Schritte in einem Prägeraum 14‴ im Vakuum mit einem dünnen, flexiblen Folienstempel geprägt wird.

Nach dem vollflächigen Kontakt zwischen Folienstempel 12" und Substrat 13" wird der flexible Folienstempel 12" gemäß Figur 3c durch einen Überdruck zwischen der äußeren Haltefläche der Folienstempel-Aufnahmeeinrichtung und dem Folienstempel 12" "losgelassen". Währenddessen verbleibt der Folienstempelrahmen 9' an der Folienstempel-Aufnahmeeinrichtung fixiert, sodass der Folienstempel 12" auf dem Substrat 13" relaxieren kann. Durch die Kapillarkräfte werden die Strukturen mit dem Prägelack gefüllt und durch die zu diesem Zeitpunkt gegebene Flexibilität kann sich der Folienstempel 12" konform der Substratoberfläche anpassen. Zusätzlich kann das Delta der Umgebungsdrücke als zusätzliche externe Kraft genutzt werden, um das Füllverhalten zu verbessern. Dafür werden der Druck hinter dem Folienstempel 12" im Folienstempel-Spülraum 23 und der Druck beziehungsweise das Vakuum im Bearbeitungsraum 14‴ gezielt eingestellt. Der Druck im Bearbeitungsraum 14‴ liegt insbesondere zwischen 1 mbar und 1100 mbar. Bei der Evakuierung ist der Druck in dem Bearbeitungsraum kleiner als 500 mbar, mit Vorzug kleiner als 300 mbar, mit größtem Vorzug kleiner als 250 mbar. Insbesondere wird bevorzugt Grobvakuum zwischen 300 mbar und 1 mbar eingestellt, am bevorzugtesten zwischen 250 mbar und 100 mbar.

Der Druck im Spülraum 23 auf der Rückseite des Folienstempels 12" liegt insbesondere zwischen 1 mbar und 1500 mbar. Der Druckunterschied zwischen Bearbeitungsraum 14‴ und Folienstempel-Spülraum 23 (Delta der Umgebungsdrücke) liegt zwischen 0 und 800 mbar, bevorzugt zwischen 100 und 600 mbar, noch bevorzugter zwischen 200 und 600 mbar. Ein Druckunterschied von 500 mbar entspricht beispielsweise einer Kraft von 4,5 kN die als zusätzliche Kraft im Prägeverfahren genutzt werden kann.

Das UV-Lampenhaus 19' ermöglicht die Bestrahlung des Prägelacks mittels UV-Licht. Dabei erfolgt bei der Aushärtung mit UV-Strahlung eine Temperaturkontrolle und bei Bedarf ein Temperaturausgleich. Das Folienstempel-Material ist bei UV-Aushärtung des Prägematerials am Substrat mit Vorzug zumindest teilweise transparent für den Wellenlängenbereich der elektromagnetischen Strahlung, welche das Prägematerial vernetzt. Die optische Transparenz ist dabei insbesondere größer als 20%, mit Vorzug größer als 50%, mit größerem Vorzug größer als 80%, mit größtem Vorzug größer als 95%. Der Folienstempel kann auch für andere Bereiche der elektromagnetischen Strahlung transparent sein. Auch andere angrenzende Bestandteile der oberen Aufnahmeeinrichtung sowie ein Abschnitt des oberen Teils der Vorrichtung, an der das UV-Lampenhaus 19' angrenzt, sind aus UV- und/oder IR-transparenten Materialien gefertigt.

Im letzten Verfahrensschritt (nicht dargestellt) erfolgt die Entformung des Folienstempels 12" von der Prägemasse. Am Ende des Verfahrens wird der Folienstempel 12" insbesondere vom Substrat 13" abgezogen und das Substrat 13" entladen. Die Anlage verfügt vorzugsweise über Sensoren zur Kraftüberwachung für eine Kontrolle des Entformungsschrittes. In der Vorrichtung gemäß Figuren 3a bis 3c befindet sich, insbesondere an der Unterseite, eine Justiereinheit 16' für die Substrat-Aufnahmeeinrichtung. Die Aufnahmeeinrichtung besitzt insbesondere sechs Freiheitsgrade, drei Freiheitsgrade der Translation entlang der X-, Y- und Z-Richtung sowie drei Freiheitsgrade der Rotation um die X-, Y- und Z-Achse. Die Translationsfreiheitsgrade dienen der Verschiebung der Aufnahmeeinrichtung und damit des Substrats 13" innerhalb der der durch die X und Y-Richtung aufgespannten X-Y Ebene sowie der Bewegung von Substrat 13" und Folienstempel 12" zueinander entlang der Z-Richtung. Die Rotationsmöglichkeit um die X-, Y- und Z-Achse dient zur Durchführung eines Keilfehlerausgleichs (engl.: wedge error compensation, WEC Z-Achse 18') und/oder der Orientierung von Substrat 13" zur Entformung.

### Bezugszeichenliste

- 1, 1', 1'': Substrataufnahmeeinrichtung, Substrat-Aufnahmeeinrichtung
- 2, 2', 2'': Einrichtung zum Bearbeiten, Folienstempelaufnahmeeinrichtung, Folienstempel-Aufnahmeeinrichtung
- 3, 3': Substrat-Aufnahmekörper, Substrathalter
- 4, 4': Folienstempel-Aufnahmekörper
- 5, 5', 5": Evakuierungsmittel, Evakuiermittel, Vakuum-Leitung
- 6, 6': Fixierelement(e) für Substrat
- 7, 7': Dichtung, Dichtmittel
- 8: Aktuator (Pin)
- 9, 9': Rahmen, Stempel-Rahmen, Folienrahmen, Film Frame
- 10, 10', 10'': Spülmittel, Gas-Leitung
- 11, 11': Fixierelement(e) für Folienrahmen
- 12, 12', 12": Bearbeitungsmittel, Prägemittel, Stempel, Prägestempel, flexibler Folienstempel
- 13, 13', 13": Substrat, Substratstapel
- 14, 14', 14", 14‴: Bearbeitungsraum, Vakuum-Prägeraum, Raum
- 15, 15o, 15u: Optiken für Ausrichtung
- 16, 16': Justiereinheit (Alignment Stage)
- 17, 17': Substrat Lade-Pins
- 18, 18': WEC Z-Achse (Wedge Error Compensation)
- 19, 19': UV-Lampenhaus
- 20, 20': Abdichtungsmittel, Gatevalve, Absperrschieber (Gate valve)
- 21: Ladeeinheit für Folienrahmen mit Folienstempel (Film Frame)
- 22: Bearbeitungseinrichtung, Kammer, Prozesskammer, Prozessmodul
- 23: Spülraum

## Patentansprüche

1. Verfahren zum Nanoprägen eines Substrats (13) mit zumindest den folgenden Schritten:
a) Bereitstellung einer Substrataufnahmeeinrichtung (1, 1', 1") zur Aufnahme des Substrats (13),
b) Bereitstellung einer Einrichtung (2, 2', 2", 22) zum Bearbeiten des Substrats (13),
c) Ausbildung eines lokalen und fluidisch dichten Bearbeitungsraums (14, 14', 14") zwischen der Substrataufnahmeeinrichtung (1, 1', 1") und der Einrichtung (2, 2', 2", 22),
d) Evakuierung des Bearbeitungsraums (14, 14', 14") und
e) Bearbeitung des Substrats (13),
wobei die Evakuierung in Schritt d) nach der Ausbildung des Bearbeitungsraums (14, 14', 14") in Schritt c) erfolgt,
**dadurch gekennzeichnet, dass** die Einrichtung (2, 2', 2", 22) einen flexiblen Folienstempel (12") zum Prägen des Substrats (13) aufweist und in Schritt e) ein fluidisch dichter Spülraum (23) zwischen der Einrichtung (22) und dem Folienstempel (12") zur Krümmung des Folienstempels (12") gespült wird, wobei der Bearbeitungsraum (14, 14', 14") und der Spülraum (23) fluidisch durch den Folienstempel (12, 12', 12") voneinander getrennt sind.

2. Verfahren nach Anspruch 1, wobei die Ausbildung des Bearbeitungsraums (14, 14', 14") durch Annäherung der Substrataufnahmeeinrichtung (1, 1', 1") und der Einrichtung (2, 2', 2") erfolgt, wobei vor der Annäherung die Einrichtung (2, 2', 2") und die Substrataufnahmeeinrichtung (1, 1', 1") zueinander ausgerichtet werden.

3. Verfahren nach Anspruch 1, wobei die Ausbildung des Bearbeitungsraums (14, 14', 14") durch steuerbare Abdichtungsmittel (20, 20') erfolgt.

4. Verfahren nach Anspruch 1, wobei ein Druckunterschied zwischen dem Druck des Bearbeitungsraumes (14, 14', 14") und des Spülraums (23) zwischen 0 und 80000 Pa, bevorzugt zwischen 10000 und 60000 Pa, noch bevorzugter zwischen 20000 und 60000 Pa zum Bearbeiten, insbesondere zum Prägen, eingestellt wird.

5. Vorrichtung zum Bearbeiten eines Substrats (13), zumindest aufweisend:
i) eine Substrataufnahmeeinrichtung (1, 1', 1") zur Aufnahme des Substrats (13),
ii) eine Einrichtung (2, 2', 2", 22) zum Bearbeiten des Substrats (13),
iii) Mittel zur Ausbildung eines lokalen und fluidisch dichten Bearbeitungsraums (14, 14', 14") zwischen der Substrataufnahmeeinrichtung (1, 1', 1") und der Einrichtung (2, 2', 2", 22)
vi) Evakuierungsmittel (5, 5') zur Evakuierung des Bearbeitungsraums (14, 14', 14")
v) Bearbeitungsmittel (12, 12', 12") zur Bearbeitung des Substrats,
wobei die Bearbeitungsmittel einen flexiblen Folienstempel (12") zum Nanoprägen des Substrats (13) aufweisen,
**dadurch gekennzeichnet, dass** die Vorrichtung zusätzlich Spülmittel (10, 10', 10") zur Ausbildung eines fluidisch dichten Spülraums (23) zwischen der Einrichtung (22) und dem Folienstempel (12") aufweist, wobei der Spülraum (23) fluidisch durch den Folienstempel (12") von dem Bearbeitungsraum (14, 14', 14") getrennt ist, und wobei der Folienstempel (12") durch die Spülmittel (10") gezielt verformbar ist.

6. Vorrichtung nach Anspruch 5, wobei die Mittel Annäherungsmittel zur Annäherung der Substrataufnahmeeinrichtung (1, 1', 1") und der Einrichtung (2, 2', 2") sind.

7. Vorrichtung nach Anspruch 6, wobei die Vorrichtung zusätzlich Ausrichtungsmittel zur Ausrichtung der Substrataufnahmeeinrichtung (1, 1', 1") und der Einrichtung (2, 2', 2", 22) zueinander aufweist, wobei die Ausrichtungsmittel so eingerichtet sind, dass vor und/oder während einem Wirken der Annäherungsmittel die Substrataufnahmeeinrichtung (1, 1', 1") und die Einrichtung (2, 2', 2") zueinander ausrichtbar sind.

8. Vorrichtung nach Anspruch 6 oder 7, wobei die Substrataufnahmeeinrichtung (1, 1', 1") und die Einrichtung (2, 2', 2", 22) korrespondierende Dichtmittel (7, 7') aufweist, wobei die Annäherungsmittel so eingerichtet sind, dass nach dem Wirken der Annäherungsmittel die korrespondierenden Dichtungsmittel (7, 7') den Bearbeitungsraum (14, 14', 14") zwischen der Substrataufnahmeeinrichtung (1, 1', 1") und der Einrichtung (2, 2', 2") ausbilden.

9. Vorrichtung nach Anspruch 5, wobei die Mittel steuerbare Abdichtungsmittel (20, 20') zur Ausbildung des Bearbeitungsraums (14, 14', 14") zwischen der Substrataufnahmeeinrichtung (1, 1', 1") und der Einrichtung (22) sind.

10. Vorrichtung nach Anspruch 9, wobei die Substrataufnahmeeinrichtung (1, 1', 1") und der Einrichtung (22) einteilig ausgebildet sind.

11. Vorrichtung nach Anspruch 5, wobei die Vorrichtung so eingerichtet ist, dass ein Druckunterschied zwischen dem Druck des Bearbeitungsraumes (14, 14', 14") und des Spülraums (23) zwischen 0 und 80000 Pa, bevorzugt zwischen 10000 und 60000 Pa, noch bevorzugter zwischen 20000 und 60000 Pa einstellbar ist.

12. Vorrichtung nach Anspruch 5 oder 11, wobei die Spülmittel (10") gleichzeitig Evakuierungsmittel sind, so dass der Folienstempel (12") von dem Substrat (13) durch Evakuierung des Spülraums (23) entformbar ist.

## Claims

1. A method for nanoimprinting a substrate (13) with at least the following steps:
a) preparation of a substrate support device (l, 1', 1") for supporting the substrate (13),
b) preparation of a device (2, 2', 2" 22) for processing the substrate (13),
c) formation of a local and fluid-tight processing chamber (14, 14', 14") between the substrate support device (l, 1', 1") and the device (2, 2', 2", 22),
d) evacuation of the processing chamber (14, 14', 14") and
e) processing the substrate (13),
wherein the evacuation in step d) is carried out after the formation of the processing chamber (14, 14', 14") in step (c),
**characterised in that** the device (2, 2', 2" 22) has a flexible foil stamp (12") for imprinting the substrate (13) and in step e) a fluid-tight flushing chamber (23) between the device (22) and the foil stamp (12") is flushed for the curvature of the foil stamp (12"), wherein the processing chamber (14, 14', 14") and the flushing chamber (23) are fluidically separated from each other by the foil stamp (12, 12', 12").

2. The method according to claim 1, wherein the formation of the processing chamber (14, 14', 14") takes place by a mutual approach of the substrate support device (l, 1', 1") and the device (2, 2', 2"), wherein the device (2, 2' 2") and the substrate support device (l, 1', 1") are aligned with each other before the approach.

3. The method according to claim l, wherein the formation of the processing chamber (14, 14', 14") is carried out by controllable sealing means (20, 20').

4. The method according to claim l, wherein a pressure difference between the pressure of the processing chamber (14, 14', 14") and the flushing chamber (23) is set between 0 and 80000 Pa, preferably between 10000 and 60000 Pa, still more preferably between 20000 and 60000 Pa for processing, in particular for imprinting.

5. A device for processing a substrate (13), comprising at least:
i) a substrate support device (l, l', l") for the supporting the substrate (13),
ii) a device (2, 2', 2" 22) for processing the substrate (13),
iii) means for the formation of a local and fluid-tight processing chamber (14, 14', 14") between the substrate support device (l, 1', 1") and the device (2, 2', 2" 22),
vi) evacuating means (5, 5') for evacuating the processing chamber (14, 14', 14")
v) processing means (12, 12', 12") for processing the substrate,
wherein the processing means comprise a flexible foil stamp (12") for nanoimprinting the substrate (13),
**characterised in that** the device additionally comprises a flushing means (10, 10', 10") to form a fluid-tight flushing chamber (23) between the device (22) and the foil stamp (12"), wherein the flushing chamber (23) is fluidically separated from the processing chamber (14, 14', 14") by the foil stamp (12"), and wherein the foil stamp (12") can be deformed in a targeted manner by the flushing means (10").

6. The device according to claim 5, wherein the means are approach means for the mutual approach of the substrate support device (l, 1', 1") and the device (2, 2', 2").

7. The device according to claim 6, wherein the device additionally comprises alignment means for aligning the substrate support device (l, 1', 1") and the device (2, 2', 2", 22) in relation to each other, wherein the alignment means are set up in such a way that the substrate support device (l, 1', 1") and the device (2, 2', 2") can be aligned with each other before and/or during an operation of the approach means.

8. The device according to claim 6 or 7, wherein the substrate support device (l, 1', 1") and the device (2, 2', 2", 22) have corresponding sealing means (7, 7'), wherein the approach means are set up in such a way that after the operation of the approach means the corresponding sealing means (7, 7') form the processing chamber (14, 14', 14") between the substrate support device (l, 1', 1") and the device (2, 2', 2").

9. The device according to claim 5, wherein the means are controllable sealing means (20, 20') for forming the processing chamber (14, 14', 14") between the substrate support device (1, 1', 1") and the device (22).

10. The device according to claim 9, wherein the substrate support device (l, 1', 1") and the device (22) are designed in one piece.

11. The device according to claim 5, wherein the device is set up in such a way that a pressure difference between the pressure of the processing chamber (14, 14', 14") and the flushing chamber (23) is adjustable between 0 and 80000 Pa, preferably between 10000 and 60000 Pa, still more preferably between 20000 and 60000 Pa.

12. The device according to claim 5 or 11, wherein the flushing means (10") are at the same time evacuating means, so that the foil stamp (12") can be demoulded from the substrate (13) by evacuating the flushing chamber (23).

## Revendications

1. Procédé de nano-marquage d'un substrat (13) comprenant au moins les étapes suivantes :
a) fourniture d'un dispositif de réception de substrat (1, 1', 1") pour recevoir le substrat (13),
b) fourniture d'un dispositif (2, 2', 2", 22) pour traiter le substrat (13),
c) formation d'un espace de traitement (14, 14', 14") local et étanche aux fluides entre le dispositif de réception de substrat (1, 1', 1") et le dispositif (2, 2', 2", 22),
d) évacuation de l'espace de traitement (14, 14', 14") et
e) traitement du substrat (13),
dans lequel l'évacuation à l'étape d) s'effectue après la formation de l'espace de traitement (14, 14', 14") à l'étape c),
**caractérisé en ce que** le dispositif (2, 2', 2", 22) présente un poinçon de film (12") flexible pour marquer le substrat (13), et à l'étape e), un espace de rinçage (23) étanche aux fluides entre le dispositif (22) et le poinçon de film (12") est rincé pour courber le poinçon de film (12"), dans lequel l'espace de traitement (14, 14', 14") et l'espace de rinçage (23) sont séparés l'un de l'autre de manière fluidique par le poinçon de film (12, 12', 12").

2. Procédé selon la revendication 1, dans lequel la formation de l'espace de traitement (14, 14', 14") s'effectue par rapprochement du dispositif de réception de substrat (1, 1', 1") et du dispositif (2, 2', 2"), dans lequel avant le rapprochement, le dispositif (2, 2', 2") et le dispositif de réception de substrat (1, 1', 1") sont alignés entre eux.

3. Procédé selon la revendication 1, dans lequel la formation de l'espace de traitement (14, 14', 14") s'effectue par des moyens d'étanchéité (20, 20') pouvant être commandés.

4. Procédé selon la revendication 1, dans lequel une différence de pression entre la pression de l'espace de traitement (14, 14', 14") et de l'espace de rinçage (23) est réglée entre 0 et 80000 Pa, de préférence entre 10000 et 60000 Pa, plus encore de préférence entre 20000 et 60000 Pa, pour le traitement, en particulier pour le marquage.

5. Dispositif de traitement d'un substrat (13), présentant au moins :
i) un dispositif de réception de substrat (1, 1', 1") pour recevoir le substrat (13),
ii) un dispositif (2, 2', 2", 22) pour traiter le substrat (13),
iii) des moyens pour former un espace de traitement (14, 14', 14") local et étanche aux fluides entre le dispositif de réception de substrat (1, 1', 1") et le dispositif (2, 2', 2", 22),
vi) des moyens d'évacuation (5, 5') pour évacuer l'espace de traitement (14, 14', 14")
v) des moyens de traitement (12, 12', 12") pour traiter le substrat,
dans lequel les moyens de traitement présentent un poinçon de film (12") flexible pour le nano-marquage du substrat (13),
**caractérisé en ce que** le dispositif présente en outre des moyens de rinçage (10, 10', 10") pour former un espace de rinçage (23) étanche aux fluides entre le dispositif (22) et le poinçon de film (12"), dans lequel l'espace de rinçage (23) est séparé de manière fluidique de l'espace de traitement (14, 14', 14") par le poinçon de film (12"), et dans lequel le poinçon de film (12") peut être déformé de manière ciblée par les moyens de rinçage (10").

6. Dispositif selon la revendication 5, dans lequel les moyens sont des moyens de rapprochement pour rapprocher le dispositif de réception de substrat (1, 1', 1") et le dispositif (2, 2', 2").

7. Dispositif selon la revendication 6, dans lequel le dispositif présente en outre des moyens d'alignement pour aligner le dispositif de réception de substrat (1, 1', 1") et le dispositif (2, 2', 2", 22) entre eux, dans lequel les moyens d'alignement sont ainsi conçus qu'avant et/ou pendant une action des moyens de rapprochement, le dispositif de réception de substrat (1, 1', 1") et le dispositif (2, 2', 2'') peuvent être alignés entre eux.

8. Dispositif selon la revendication 6 ou 7, dans lequel le dispositif de réception de substrat (1, 1', 1") et le dispositif (2, 2', 2", 22) présentent des moyens d'étanchéité (7, 7') correspondants, dans lequel les moyens de rapprochement sont ainsi conçus qu'après l'action des moyens de rapprochement, les moyens d'étanchéité (7, 7') correspondants forment l'espace de traitement (14, 14', 14") entre le dispositif de réception de substrat (1, 1', 1") et le dispositif (2, 2', 2").

9. Dispositif selon la revendication 5, dans lequel les moyens sont des moyens d'étanchéité (20, 20') pouvant être commandés pour former l'espace de traitement (14, 14', 14") entre le dispositif de réception de substrat (1, 1', 1") et le dispositif (22).

10. Dispositif selon la revendication 9, dans lequel le dispositif de réception de substrat (1, 1', 1") et le dispositif (22) sont formés d'une seule pièce.

11. Dispositif selon la revendication 5, dans lequel le dispositif est ainsi conçu qu'une différence de pression entre la pression de l'espace de traitement (14, 14', 14") et de l'espace de rinçage (23) peut être réglée entre 0 et 80000 Pa, de préférence entre 10000 et 60000 Pa, plus encore de préférence entre 20000 et 60000 Pa.

12. Dispositif selon la revendication 5 ou 11, dans lequel les moyens de rinçage (10") sont parallèlement des moyens d'évacuation, de façon à ce que le poinçon de film (12") puisse être démoulé du substrat (13) par l'évacuation de l'espace de rinçage (23).
